# EUROPEAN PATENT APPLICATION

(11) **EP 4 682 860 A1**
(43) Date of publication of application: **21.01.2026**
(21) Application number: 25179778.3
(22) Date of filing: 30.05.2025
(51) Int. Cl.: G09G 3/32

(54) **DISPLAY DEVICE**

(30) Priority: 17.07.2024 KR 20240094419
(71) Applicant: LG Display Co., Ltd., Seoul, 07336 (KR)
(72) Inventor: KIM, JungTae, 10845 Paju-si (KR); BAE, DongGeun, 10845 Paju-si (KR)
(74) Representative: Ter Meer Steinmeister & Partner

(57) **Abstract**

A display device according to one embodiment of the present disclosure may include: a substrate on which a plurality of pixels including a plurality of main sub pixels are defined; a plurality of redundancy sub pixels disposed between the plurality of main sub pixels; one or more pixel drive circuits disposed on the substrate; a plurality of main micro-LEDs disposed in the plurality of main sub pixels and electrically connected to the pixel drive circuit; and a plurality of redundancy micro-LEDs disposed in the plurality of redundancy sub pixels and electrically connected to the pixel drive circuit, in which a pair of pixels, among the plurality of pixels, share the plurality of redundancy sub pixels. Therefore, the plurality of pixels use and share the plurality of redundancy sub pixels, such that the number of redundancy sub pixels may be reduced, and manufacturing costs may be reduced.

## Description

### Technical Field

The present disclosure relates to a display device, and particularly to, for example, without limitation, a display device capable of reducing the number of redundancy sub pixels.

### Description of the Related Art

Display devices are being applied to various electronic devices such as TVs, mobile phones, notebook computers, and tablet computers.

As the display devices, there are an organic light-emitting display (OLED) configured to autonomously emit, and a liquid crystal display (LCD) that requires a separate light source.

Recently, a display device including micro-light emitting diodes (micro-LEDs, mLEDs, or µLEDs) as light-emitting elements has attracted attention as a next-generation display device. Because the micro-LED is made of an inorganic material instead of an organic material, the micro-LED may be quickly turned on or off, have excellent luminous efficiency, and display high-luminance images in comparison with the liquid crystal display device or the organic light-emitting display device.

The description provided in the background section should not be assumed to be prior art merely because it is mentioned in or associated with the background section. The background section may include information that describes one or more aspects of the subject technology.

### SUMMARY

An object of the present disclosure is to provide a display device capable of simplifying structures of a plurality of pixel circuits.

Another object of the present disclosure is to provide a display device capable of operating with low power consumption by integrating a plurality of pixel circuits into a single micro-driver.

Still another object of the present disclosure is to provide a display device in which a pair of pixels use and share a plurality of redundancy sub pixels, which reduces the number of redundancy sub pixels.

Yet another object of the present disclosure is to provide a display device capable of reducing manufacturing costs by reducing the number of redundancy sub pixels.

At least one or more of these objects are solved by the features of the independent claims. Objects of the present disclosure are not limited to the above-mentioned object, and other object, which are not mentioned above, can be clearly understood by those skilled in the art from the following descriptions.

In one aspect of the present disclosure, a display device comprises a substrate on which a plurality of pixels is defined, wherein each of the pixels comprises a plurality of main sub pixels and each of the plurality of main sub pixels comprises a main micro-LED; and a plurality of redundancy sub pixels defined on the substrate and disposed between a pair of pixels adjacent to each other among the plurality of pixels, wherein each of the plurality of redundancy sub pixels comprises a redundancy micro-LED. The display device may further comprise a second electrode electrically connected to (and/or disposed on) the main micro-LEDs of the main sub pixels of one pixel and a redundancy micro-LED of at least one of the redundancy sub pixels.

A display device according to an aspect of the present disclosure includes: a substrate on which a plurality of pixels each including a plurality of main sub pixels are defined; a plurality of redundancy sub pixels disposed between a pair of pixels adjacent to each other among the plurality of pixels; a plurality of main micro-LEDs disposed in the plurality of main sub pixels; and a plurality of redundancy micro-LEDs disposed in the plurality of redundancy sub pixels, wherein the pair of pixels share the plurality of redundancy sub pixels. Therefore, the plurality of pixels use and share the plurality of redundancy sub pixels, such that the number of redundancy sub pixels may be reduced, and manufacturing costs may be reduced.

In another aspect of the present disclosure, a display device includes: a substrate on which first and second pixels each including a plurality of main sub pixels and disposed to be spaced apart from each other in a first direction are defined; a plurality of redundancy sub pixels disposed between the first pixel and the second pixel; and a plurality of micro-LEDs disposed in the plurality of main sub pixels and the plurality of redundancy sub pixels, wherein at least one of the plurality of redundancy sub pixels is included in the first pixel, and at least another one of the plurality of redundancy sub pixels is included in the second pixel. Therefore, the plurality of redundancy sub pixels capable of preparing for a defect of any one of the plurality of main sub pixels of the first and second pixels are provided, which may improve the quality of the display device.

The display device according to any one of these aspects may include one or more of the following features:

Each of the pixels may comprise a plurality of main sub pixels, e.g. three main sub pixels. The plurality of main sub pixels may be configured to emit light of (at least two) different colors. A defective main sub pixel may include a main sub pixel without micro-LED (i.e. micro-LED is missing) or a main sub pixel with a defective micro-LED (i.e. incapable of emitting light).

The plurality of pixels may be arranged in columns and rows. The plurality of pixels may be identical, i.e. have identical structure. Each of the main sub pixels and of the redundancy sub pixels may comprise one micro-LED. The redundancy sub pixels between two adjacent pixels may correspond in number and/or color to the main sub pixels contained in one or each of said two pixels. The plurality of main sub pixels of each pixel may be disposed in one row and/or the plurality of redundancy sub pixels between the two adjacent pixels may be disposed in one row. The main sub pixels of one pixel may be adjacent on their one side to other main sub pixels of another pixel and on their other side to redundancy sub pixels. In other words, each pixel of the plurality of pixels may be adjacent to another pixel and to a plurality of redundancy sub pixels. Between two adjacent pixels of the plurality of pixels, either at least one communication line or a plurality of redundancy sub pixels may be disposed.

The pair of pixels (i.e. the two adjacent pixels) may share the plurality of redundancy sub pixels therebetween. That is, at least one of the plurality of redundancy sub pixels may be included in one of the pair of pixels, and/or at least another one of the plurality of redundancy sub pixels may be included in the other one of the pair of pixels.

The display device may include a pixel drive circuit disposed on the substrate.

The driving circuit may include a driving transistor and/or an emission transistor. A gate of the driving transistor may be connected to a scan line. A gate of the emission transistor may be connected to an emission line.

The display device may include a plurality of first electrodes electrically connected to the plurality of main micro-LEDs and the plurality of redundancy micro-LEDs. The plurality of first electrodes may be electrically connected respectively to (some of ) the plurality of main micro-LEDs or to (some of) the plurality of redundancy micro-LEDs. The display device may include a plurality of signal lines configured to electrically connect the plurality of first electrodes and the pixel drive circuit. The plurality of first electrodes and the plurality of signal lines may be configured to transmit an anode voltage, which is outputted from the pixel drive circuit, to the plurality of main micro-LEDs and the plurality of redundancy micro-LEDs.

The plurality of signal lines may be provided on the substrate. The signal lines may extend in a (first) direction perpendicular to a (second) direction along which the redundancy sub pixels and/or the main sub pixels of one pixel are arranged. A first signal line may be connected to main sub pixels of pixels which are arranged along the first signal line and/or in a first direction. A second signal line may be connected to redundancy sub pixels. The first and the second signal line may extend in parallel to each other.

The display device may include a plurality of communication lines. The plurality of communication lines may extend in a direction perpendicular to the plurality of signal lines. For instance, the plurality of signal lines may extend in column direction and the plurality of communication lines may extend in row direction.

The pair of pixels may be commonly driven by the pixel drive circuit. The pair of pixels may be spaced apart from each other in a first direction (e.g. column direction). The pair of pixels may include a first pixel and a second pixel.

The signal lines electrically connected to the plurality of main micro-LEDs, among the plurality of signal lines, and signal lines electrically connected to the plurality of redundancy micro-LEDs, among the plurality of signal lines, may be alternately arranged on the substrate.

The display device may include a plurality of banks configured to support the plurality of main micro-LEDs and the plurality of redundancy micro-LEDs. The plurality of first electrodes may be disposed between the plurality of main micro-LEDs and the plurality of banks and/or between the plurality of redundancy micro-LEDs and the plurality of banks.

The plurality of banks may be separated from each other.

The display device may include a pixel drive circuit disposed on the substrate and electrically connected to the plurality of main micro-LEDs and plurality of redundancy micro-LEDs. The display device may include a plurality of contact electrodes electrically connected to the pixel drive circuit. The display device may include one or more second electrodes electrically connected to the plurality of contact electrodes. In particular, each of the second electrodes may be electrically connected to one of the contact electrodes. The main sub pixels of one pixel may share one of the second electrodes, i.e. have the same second electrode. The plurality of main sub pixels of one of the two adjacent pixels and at least one of the plurality of redundancy pixels may share one of the second electrodes, i.e. have the same second electrode. In addition, the plurality of main sub pixels of the other one of the two adjacent pixels and at least another one of the plurality of redundancy pixels may share one of the second electrodes, i.e. have another same second electrode. The second electrode and the plurality of contact electrodes may be configured to transmit a cathode voltage, which is outputted from the pixel drive circuit, to the plurality of main micro-LEDs and the plurality of redundancy micro-LEDs.

The pair of pixels may include a first pixel, which comprises the plurality of main sub pixels disposed in an n-th row among the plurality of pixels, and/or a second pixel, which comprises the plurality of main sub pixels disposed in an (n+2)th row among the plurality of pixels. The first and second pixels may share the plurality of redundancy sub pixels disposed in an (n+1)th row.

The plurality of main sub pixels may comprise a first main sub pixel, a second main sub pixel, and a third main sub pixel, and the plurality of redundancy sub pixels may comprise a first redundancy sub pixel, a second redundancy sub pixel, and a third redundancy sub pixel.

The pair of pixels may be pixels disposed in different rows with the plurality of redundancy sub pixels interposed therebetween. The first redundancy sub pixel may be disposed between the first main sub pixels of the pair of pixels. The second redundancy sub pixel may be disposed between the second main sub pixels of the pair of pixels. The third redundancy sub pixel may be disposed between the third main sub pixels of the pair of pixels.

The display device may include a plurality of second electrodes disposed on the plurality of main micro-LEDs and the plurality of redundancy micro-LEDs. The display device may include a black matrix disposed on the plurality of second electrodes and comprising a plurality of transmission holes. The plurality of transmission holes may overlap some of the plurality of main micro-LEDs and some of the plurality of redundancy micro-LEDs.

One of the pair of pixels may be configured to emit light by a combination of some of the plurality of main sub pixels and at least one of the plurality of redundancy sub pixels.

The plurality of main sub pixels of one pixel and at least one of the plurality of redundancy sub pixels may be configured to share one of the plurality of second electrodes.

The plurality of main sub pixels of one pixel may be configured to share one of the plurality of second electrodes. One second electrode may extend to at least one of the plurality of redundancy sub pixels.

The remaining pixel of the pair of pixels may be configured to emit light by a combination of some of the plurality of main sub pixels and at least one of the remaining redundancy sub pixels, except for the redundancy sub pixel used for one pixel.

Each of the plurality of main micro-LEDs and the plurality of redundancy micro-LEDs may include an anode electrode, a first semiconductor layer disposed on the anode electrode, an active layer disposed on the first semiconductor layer, a second semiconductor layer disposed on the active layer, and a cathode electrode disposed on the second semiconductor layer.

The display device may include a first electrode disposed below each of the plurality of main micro-LEDs and each of the plurality of redundancy micro-LEDs and configured to electrically connect the pixel drive circuit and the anode electrode. The display device may include a solder pattern disposed between the first electrode and the anode electrode. The first electrode and the anode electrode may be electrically connected by eutectic bonding using the solder pattern.

The display device may include a plurality of second electrodes disposed on the plurality of micro-LEDs and electrically connected to cathode electrodes of the plurality of micro-LEDs. The plurality of second electrodes may be not disposed on the plurality of redundancy micro-LEDs.

The plurality of main sub pixels of the first pixel may include a first main sub pixel capable of emitting light, a second main sub pixel capable of emitting light, and a third main sub pixel having a lighting defect. The plurality of main sub pixels of the second pixel may include a second main sub pixel capable of emitting light, a third main sub pixel capable of emitting light, and a first main sub pixel having a lighting defect.

The plurality of redundancy sub pixels may include a first redundancy sub pixel, a second redundancy sub pixel, and a third redundancy sub pixel. The first pixel may be configured to emit light by a combination of the first main sub pixel, the second main sub pixel, and the third redundancy sub pixel. The second pixel may be configured to emit light by a combination of the first redundancy sub pixel, the second main sub pixel, and the third main sub pixel.

Each of the first pixel and the second pixel, i.e. each of the pair of pixels, may comprise three main sub pixels. Between the first pixel and the second pixel, i.e. between the pair of pixels, three redundancy sub pixels may be disposed. The main sub pixels of the first pixel, the main sub pixels of the second pixel, and the three redundancy sub pixels may respectively be disposed in one direction (e.g. in row direction). One of the three main sub pixels of the first pixel and one of the three main sub pixels of the second pixel may be defective, wherein the defective main sub pixel of the first pixel is substituted by one of the three redundancy sub pixels and the defective main sub pixel of the second pixel is substituted by another one of the three redundancy sub pixels. The present disclosure is not limited to the pixels comprising three main sub pixels and to three redundancy sub pixels, but a number of the sub pixels may be two, three, four, or more.

The display device may further include a plurality of second electrodes disposed on the plurality of micro-LEDs. The plurality of main sub pixels and the third redundancy sub pixel of the first pixel may share one of the plurality of second electrodes. The plurality of main sub pixels and the first redundancy sub pixel of the second pixel may share another of the plurality of second electrodes.

The display device may further include a black matrix disposed on the plurality of second electrodes. The black matrix may include a plurality of transmission holes configured to transmit light from the plurality of micro-LEDs. The first main sub pixel and the second main sub pixel among the plurality of main sub pixels of the first pixel and the second main sub pixel and the third main sub pixel among the plurality of main sub pixels of the second pixel may overlap the plurality of transmission holes. The first redundancy sub pixel and the third redundancy sub pixel among the plurality of redundancy sub pixels may overlap the plurality of transmission holes.

The third main sub pixel of the first pixel, the first main sub pixel of the second pixel and the second redundancy sub pixel may be covered by the black matrix.

Other detailed matters of the exemplary embodiments are included in the detailed description and the drawings.

According to the present disclosure, the plurality of pixel circuits is integrated into the single pixel drive circuit, such that the display device may efficiently operate with low power consumption.

According to the present disclosure, the plurality of pixel circuits is integrated into the single micro-driver, which may simplify the structure of the display device.

According to the present disclosure, the pair of pixels may use and share the plurality of redundancy sub pixels, which may reduce the number of redundancy sub pixels and reduce costs required to manufacture the display device.

The effects according to the present disclosure are not limited to the contents exemplified above, and more various effects are included in the present disclosure

It is to be understood that both the foregoing general description and the following detailed description are exemplary and explanatory and are intended to provide further explanation of the inventive concepts as claimed..

### BRIEF DESCRIPTION OF DRAWINGS

The accompanying drawings, that may be included to provide a further understanding of the disclosure and may be incorporated in and constitute a part of the disclosure, illustrate embodiments of the disclosure and together with the description serve to explain various principles of the disclosure.

The above and other aspects, features and other advantages of the present disclosure will be more clearly understood from the following detailed description taken in conjunction with the accompanying drawings, in which:
FIG. 1 is a perspective view illustrating a display device according to an example embodiment of the present disclosure;
FIG. 2 is a top plan view of the display device according to the example embodiment of the present disclosure;
FIG. 3 is an enlarged view of the display device according to the example embodiment of the present disclosure;
FIG. 4 is a view illustrating a circuit structure according to the example embodiment of the present disclosure;
FIGS. 5 to 7 are top plan views of the display device according to the example embodiment of the present disclosure;
FIG. 8 is a cross-sectional view of the display device according to the example embodiment of the present disclosure;
FIG. 9 is a cross-sectional view of the display device according to the example embodiment of the present disclosure;
FIGS. 10 to 12 are top plan views of the display device according to the example embodiment of the present disclosure;
FIGS. 13A and 13B are cross-sectional views of the display device according to the example embodiment of the present disclosure; and
FIGS. 14 to 17 are views illustrating devices to which the display device according to example embodiments of the present disclosure are applied.
Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE EMBODIMENT

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

Advantages and features of the present disclosure and a method of achieving the advantages and features will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Any implementation described herein as an "example" is not necessarily to be construed as preferred or advantageous over other implementations.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the disclosure. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with a more limiting term such as "only". An element described in the singular form is intended to include a plurality of elements, and vice versa, unless the context clearly indicates otherwise.

In construing an element, the element is construed as including an ordinary error range or tolerance range although there is no explicit description of such an error or tolerance range.

Where positional relationships are described, for example, where the positional relationship between two parts is described using "on," "over," "under," "above," "below," "beneath," "near," "close to," or "adjacent to," "beside," "next to," or the like, one or more other parts may be disposed between the two parts unless a more limiting term, such as "immediate(ly)," "direct(ly)," or "close(ly)" is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which a third structure is disposed or interposed therebetween. Furthermore, the terms "left," "right," "top," "bottom, "downward," "upward," "upper," "lower," and the like refer to an arbitrary frame of reference.

When the temporal relationship is described using the terms such as "after", "following", "subsequent", "next to", and "before", there may also be cases where they are not consecutive, unless a more limiting term, such as "immediately" or "directly" is used.

Although the terms "first", "second", "A", "B", "(a)", "(b)" and the like are used for describing various components, the essence, sequence, order, or number of these components are not confined by these terms. These terms are merely used for distinguishing one component from the other components. For example, a first component could be termed a second component, and, similarly, a second component could be termed a first component, without departing from the scope of the present disclosure.

In describing components of this disclosure, terms such as first, second, A, B, (a), or (b) may be used. These terms are only intended to distinguish the components from other components, and the nature, order, sequence, or number of components are not limited by the terms.

When a component is described as being "connected", "coupled", "bonded" or "attached" to another component, it should be understood that the component may be directly connected, coupled, bonded, or attached to the other component, but that other components may be interposed between each component that may be indirectly connected, coupled, bonded, or attached without any specific explicit description.

When a component or layer is described as being "contacted" or "overlapped", it should be understood that the component or layer may directly contact or overlap the other component or layer, but that other components may be interposed between each component that may be indirectly contacted or overlapped without any specific explicit description.

"At least one" should be understood to include any combination of one or more of the associated components. For example, "at least one of the first, second, and third components" can be interpreted to include not only the first, second, or third components, but also any combination of two or more of the first, second, and third components.

"First direction," "Second direction," "Third direction," "row direction", "column direction", "X-axis direction," "Y-axis direction," and "Z-axis direction" should not be interpreted as a geometric relationship in which the relationship between each other is perpendicular, but can mean a wider directionality within the range in which the configuration of the present disclosure can function functionally.

Each feature of the various embodiments of the present disclosure can be partially or wholly combined or combined with each other, and various technical connections and operations are possible, and each embodiment can be implemented independently of each other or can be implemented together in a related relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, various example embodiments of the present disclosure will be described in detail with reference to the drawings. Further, all the components of each display device according to all embodiments of the present disclosure are operatively coupled and configured.

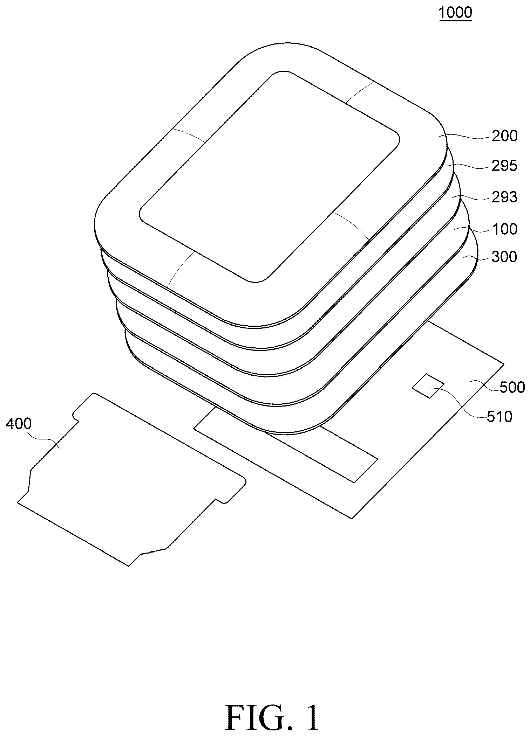

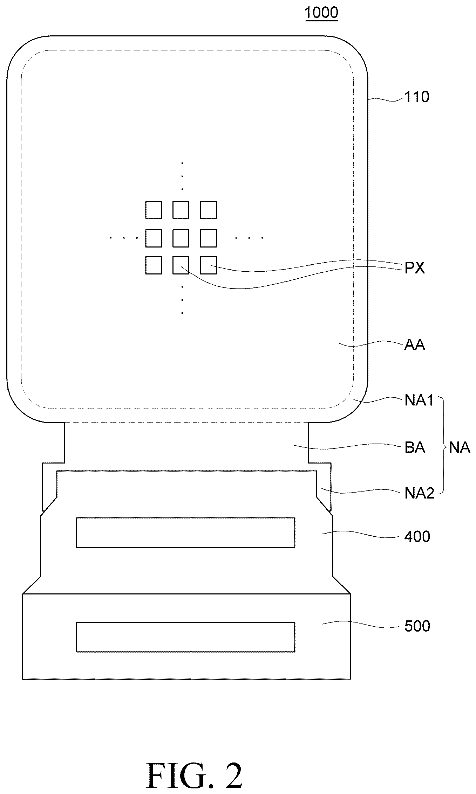

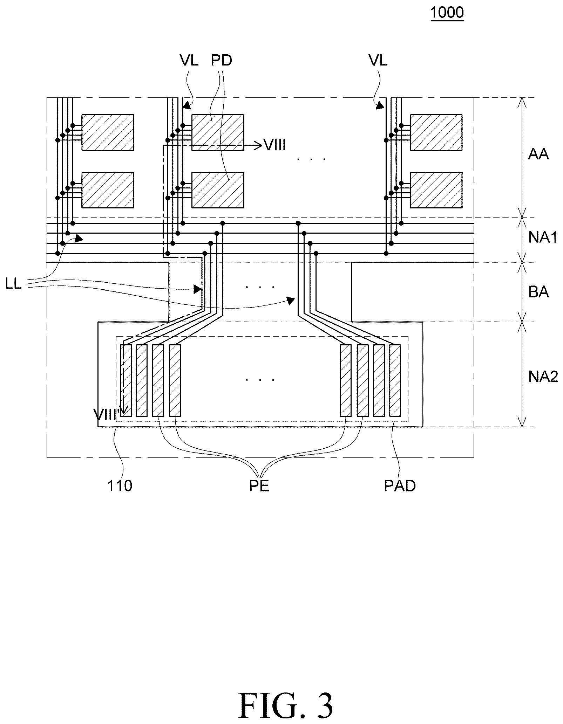

FIG. 1 is a perspective view illustrating a display device according to an exemplary embodiment of the present disclosure. FIG. 2 is a plan view of a display device according to an exemplary embodiment of the present disclosure. FIG. 3 is an enlarged view of a display device according to an exemplary embodiment of the present disclosure.

Referring to FIGS. 1 to 3, a display device 1000 according to an exemplary embodiment of the present disclosure may include one or more of a display panel 100, a polarization layer 293, an adhesive layer 295, a cover member 200, a support substrate 300, a flexible circuit board 400, and a printed circuit board 500. However, the present disclosure is not limited thereto, and more or less components may be included in the display device of the present disclosure. For example, various other function layers such as a diffusion layer, a reflective layer may also be disposed on the display panel 100.

For example, the display panel 100 of the display device 1000 may include a substrate 110. The substrate 110 may be a member which supports other components of the display device 1000. The substrate 110 is formed of an insulating material. For example, the substrate 110 may be formed of glass or resin. Further, the substrate 110 may also be formed of a material having a flexibility. For example, the substrate 110 may be formed of a plastic material having flexibility, such as any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC), polyvinyl alcohol(PVA), polyimide(PI), and polystyrene(PS). However, the exemplary embodiments of the present disclosure are not limited thereto.

The display panel 100 may implement information, videos, and/or images which are provided to users. For example, the display panel 100 may include an active area AA and a non-active area NA adjacent to the active area AA. For example, the substrate 110 may include an active area (or display area) AA and a non-active area (or non-display area) NA. However, the active area AA and the non-active area NA are not mentioned to be limited to the substrate 110, but mentioned for the entire display device 1000.

The active area AA is an area where images are displayed. The active area AA includes a plurality of pixels PX. Each of the plurality of pixels PX may include a plurality of sub pixels. A plurality of light emitting diodes may be disposed in the plurality of sub pixels respectively. The plurality of light emitting diodes may be configured in different manners depending on the type of the display device 1000. For example, when the display device 1000 is an inorganic light emitting display device, the light emitting diode may be an inorganic-based light emitting device, such as a light emitting diode (LED), a micro light emitting diode (micro LED), or a mini light emitting diode (mini LED), but the exemplary embodiments of the present disclosure are not limited thereto. Hereinafter, the description will be made by assuming that the light emitting diode of the display device 1000 according to the exemplary embodiment of the present disclosure is a micro LED, but the exemplary embodiments of the present disclosure are not limited thereto.

The non-active area NA is an area where no image is displayed. In the non-active area NAA, various wiring lines and circuits for driving the plurality of pixels PX of the active area AA may be disposed. For example, in the non-active area NA, various wiring lines and driving circuits may be mounted and a pad unit PAD to which an integrated circuit and a printed circuit are connected may be disposed, but the exemplary embodiments of the present disclosure are not limited thereto.

For example, the driving circuit may be a data driving circuit and/or a gate driving circuit, but the exemplary embodiments of the present disclosure are not limited thereto. Wiring lines through which a control signal for controlling driving circuits is supplied may be disposed on the substrate 110. For example, the control signal may include various timing signals including a clock signal, an input data enable signal, and synchronization signals, but the exemplary embodiments of the present disclosure are not limited thereto. The control signal may be received through the pad unit PAD. For example, in the non-active area NA, link lines LL may be disposed to transmit signals. For example, driving components, such as the flexible circuit board 400 and the printed circuit board 500, may be connected to the pad unit PAD.

According to the present disclosure, the non-active area NA may include a first non-active area NA1, a bending area BA, and a second non-active area NA2. For example, the first non-active area NA1 may be an area which encloses or at least partially surrounds at least a part of the active area AA. The bending area BA is an area extending from at least one side, among a plurality of sides of the first non-active area NA1 and may be a bendable or flexible area. The bending area BA may extend between from one side of the display panel to the opposite side. The bending area BA may be positioned between the first active area and the second active area. In other words, the bending area BA may divide the non-active area NA into three parts, the first non-active area NA1, the bending area BA and the second non-active area NA2. The second non-active area NA2 is an area extending from the bending area BA and the pad unit PAD may be disposed therein. For example, the bending area BA is in a bent state and the other areas of the substrate 110 excluding the bending area BA may be in a flat state. In this case, as the bending area BA is bent, the second non-active area NA2 may be located on a rear surface of the active area AA while the first non-active area NA1 and the active area AA are on a front surface of the display device, e.g. thereby minimizing a bezel width of the device, but the exemplary embodiments of the present disclosure are not limited thereto.

The active area AA of the substrate 110 or the display device 1000 may be configured with various shapes depending on a design of the display device 1000. For example, the active area may be configured with a rectangular shape formed with four rounded corners, but the exemplary embodiments of the present disclosure are not limited thereto. As another example, the active area AA may be configured with a rectangular shape formed with four right-angled corners or a circular shape, but the exemplary embodiments of the present disclosure are not limited thereto.

According to the present disclosure, a width of the second non-active area NA2 in which the plurality of pad electrodes PE is disposed may be larger than a width of the bending area BA in which only a plurality of link lines LL is disposed. Further, a width of the active area AA in which the plurality of sub pixels is disposed may be larger than a width of the bending area BA in which only a plurality of link lines LL is disposed. Even though in the drawing, it is illustrated that the width of the bending area BA is smaller than a width of the other area of the substrate 110, the shape of the substrate 110 including the bending area BA is illustrative and the exemplary embodiments of the present disclosure are not limited thereto.

Referring to FIG. 3, a plurality of pixel drive circuits PD may be disposed in the active area AA. The plurality of pixel drive circuits PD may be circuits for driving micro LEDs of the plurality of sub pixels. Each of the plurality of pixel drive circuits PD includes a plurality of transistors including a driving transistor and a storage capacitor and supplies a control signal, a power, and a driving current to the micro LEDs of the plurality of sub pixels to control an emission operation of the plurality of micro LEDs. For example, the pixel drive circuit PD may include a power line and a signal line for controlling emission on/off and/or an emission time of the micro LED. For example, the plurality of pixel drive circuits PD may be driving drivers manufactured using a metal-oxide-silicon field effect transistor (MOSFET) manufacturing process on a semiconductor substrate, but the exemplary embodiments of the present disclosure are not limited thereto. The driving driver includes a plurality of pixel drive circuits PD and may drive a plurality of sub pixels.

Referring to FIG. 1 together, the flexible circuit board 400 and the printed circuit board 500 may be disposed below the display panel 100. The flexible circuit board 400 and the printed circuit board 500 may be disposed at least at one edge of the display panel 100, but the exemplary embodiments of the present disclosure are not limited thereto. One side of the flexible circuit board 400 is attached to the display panel 100 and the other side is attached to the printed circuit board 500, but the exemplary embodiments of the present disclosure are not limited thereto. The flexible circuit board 400 may be a flexible film, but the exemplary embodiments of the present disclosure are not limited thereto.

A pad unit PAD including a plurality of pad electrodes PE may be disposed in the second non-active area NA2. In the pad unit PAD, a driving component including one or more flexible circuit board (or a flexible film) 400 and the printed circuit board 500 may be attached or bonded. The plurality of pad electrodes PE of the pad unit PAD is electrically connected to one or more flexible circuit boards (or flexible films) 400 and may transmit various signals (or powers) from the printed circuit board 500 and the flexible circuit board (or a flexible film) 400 to the plurality of pixel drive circuits PD of the active area AA.

The flexible circuit board (or flexible film) 400 may be a film on which various components are disposed on a base film having ductility. For example, driving ICs such as a gate driver IC or a data driver IC may be disposed in the flexible circuit board (or flexible film) 400, but the exemplary embodiments of the present disclosure are not limited thereto. The driving IC may be a component which processes data and driving signals to display images. The driving IC may be disposed by a chip on glass (COG), a chip on film (COF), or a tape carrier package (TCP) technique depending on a mounting method, but the exemplary embodiments of the present disclosure are not limited thereto. The flexible circuit board (or flexible film) 400 may be attached or bonded onto the plurality of pad electrodes PE through a conductive adhesive layer, but the exemplary embodiments of the present disclosure are not limited thereto.

The printed circuit board 500 may be a component which is electrically connected to one or more flexible circuit boards (or flexible films) 400 and supplies a signal to the driving IC. The printed circuit board 500 is disposed at one side of the flexible circuit board (or flexible film) 400 to be electrically connected to the flexible circuit board (or flexible film) 400. On the printed circuit board 500, various components for supplying various signals to the driving IC may be disposed. For example, on the printed circuit board 500, various components, such as a timing controller, a power source, a memory, or a processor, may be disposed. For example, the printed circuit board 500 may include a power management integrated circuit (PMIC), but the exemplary embodiments of the present disclosure are not limited thereto.

The printed circuit board 500 may include at least one hole 510, but the exemplary embodiments of the present disclosure are not limited thereto. An internal component which senses ambient light or temperature to be supplied to a plurality of sensors may be disposed in an area corresponding to at least one hole 510. For example, the internal component may include an ambient light sensor (ALS) or a temperature sensor, but the exemplary embodiments of the present disclosure are not limited thereto. For example, the hole 510 may be a transmission hole, but the exemplary embodiments of the present disclosure are not limited thereto.

Referring to FIG. 1, a polarization layer 293 may be disposed on the display panel 100. The polarization layer 293 may suppress or reduce the influence on the micro LED caused by light generated from an external light source and entering the display panel 100. In another example, an adhesive layer may be disposed between the polarization layer 293 and the display panel 100.

A cover member 200 may be disposed on the polarization layer 293. The cover member 200 may be a member for protecting the display panel 100. An adhesive layer 295 may be disposed between the polarization layer 293 and the cover member 200. The cover member 200 may be attached to the display panel 100 using the adhesive layer 295. The adhesive layer 295 may include an optically clear adhesive (OCA), an optically clear resin (OCR), or a pressure sensitive adhesive (PSA), but the exemplary embodiments of the present disclosure are not limited thereto.

A support substrate 300 may be disposed between the display panel 100 and the printed circuit board 500. The support substrate 300 may reinforce a rigidity of the display panel 100. The support substrate 300 may be a back plate, but the exemplary embodiments of the present disclosure are not limited thereto. The support substrate 300 may be omitted when necessary.

Referring to FIGS. 1 to 3, the plurality of link lines LL may be disposed in the non-active area NA. The plurality of link lines LL may be wiring lines which transmit various signals from one or more flexible circuit boards (or flexible films) 400 and the printed circuit board 500 to the active area AA. The plurality of link lines LL extends from the plurality of pad electrodes PE of the second non-active area NA2 toward the bending area BA and the first non-active area NA1 to be electrically connected to the plurality of driving lines VL of the active area AA. The plurality of pixel drive circuits PD is supplied with signals from one or more flexible circuit boards (or flexible films) 400 and the printed circuit board 500 through the driving line VL of the active area AA and the link line LL of the non-active area NA to be driven.

For example, the plurality of driving lines VL may be wiring lines for transmitting a signal output from the flexible circuit board (or flexible film) 400 and the printed circuit board 500 to the plurality of pixel drive circuits PD together with the plurality of link lines LL. The plurality of driving lines VL is disposed in the active area AA to be electrically connected to each of the plurality of pixel drive circuits PD. The plurality of driving lines VL extends toward the non-active area NA from the active area AA to be electrically connected to the plurality of link lines LL. Accordingly, a signal output from the flexible circuit board (or flexible film) 400 and the printed circuit board 500 may be transmitted to each of the plurality of pixel drive circuits PD through the plurality of link lines LL and the plurality of driving lines VL.

As the bending area BA is bent, a part of the plurality of link lines LL is bent together. A stress is concentrated in the bent part of the link line LL, which causes a crack on the link line LL. Accordingly, the plurality of link lines LL may include a conductive material having excellent ductility to reduce the crack caused when the bending area BA is bent. For example, the plurality of link lines LL may include a conductive material having excellent ductility, such as gold (Au), silver (Ag), or aluminum (Al), but the exemplary embodiments of the present disclosure are not limited thereto. Further, the plurality of link lines LL may include one of various conductive materials used for the active area AA. For example, the plurality of link lines LL may include molybdenum (Mo), chrome (Cr), titanium (Ti), nickel (Ni), neodymium (Nd), copper (Cu), and an alloy of silver (Ag) and magnesium (Mg) or an alloy thereof, but the exemplary embodiments of the present disclosure are not limited thereto. The plurality of link lines LL may include a multi-layered structure (such as a double layer structure or a triple layer structure) including various conductive materials. For example, the plurality of link lines LL may be configured with a triple layered structure of titanium (Ti)/aluminum (Al)/titanium (Ti), but the exemplary embodiments of the present disclosure are not limited thereto.

The plurality of link lines LL may be configured with various shapes to reduce a stress. At least a part of the plurality of link lines LL disposed on the bending area BA may extend in the same direction as an extending direction of the bending area BA or extend in a different direction from the extending direction of the bending area BA to reduce a stress. For example, when the bending area BA extends in one direction toward the second non-active area NA2 from the first non-active area NA1, at least a part of the link line LL disposed on the bending area BA may extend in an inclined direction from one direction. As another example, at least a part of the plurality of link lines LL may include various shapes of patterns. For example, at least a part of the plurality of link lines LL disposed on the bending area BA may have a shape in which a conductive pattern having at least one shape of a diamond shape, a rhombus shape, a trapezoidal wave shape, a triangular wave shape, a sawtooth wave shape, a sine wave shape, a circular shape, an omega (Ω) shape is repeatedly disposed. However, the exemplary embodiments of the present disclosure are not limited thereto. Accordingly, in order to minimize or reduce a stress concentrated on the plurality of link lines LL and a crack caused thereby, a shape of the plurality of link lines LL may be various shapes including the above-mentioned shapes, but the exemplary embodiments of the present disclosure are not limited thereto.

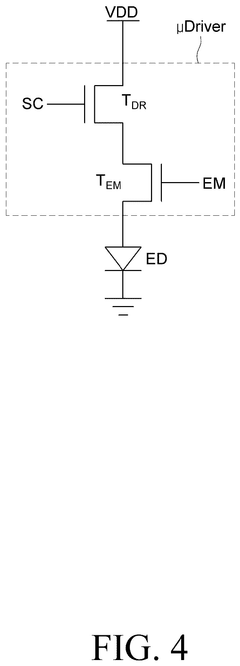

FIG. 4 is a view illustrating a circuit structure according to an exemplary embodiment of the present disclosure.

A pixel drive circuit PD may include a micro driver (µDriver). The micro LED (ED) is electrically connected to the micro driver (µDriver) of the pixel drive circuit PD to be driven. Even though in FIG. 4, it is illustrated that one micro LED (ED) is connected to one micro driver (µDriver), but the present disclosure is not limited thereto. For example, eight micro LEDs (ED) may be connected to one micro driver (µDriver). As another example, 16 micro LEDs (ED) may be connected to one micro driver (µDriver) or 32 micro LEDs (ED) or 64 micro LED (ED) may be simultaneously connected to one micro driver (µDriver).

One micro driver (µDriver) may include a driving transistor T_{DR} and an emission transistor T_{EM}, but the exemplary embodiments of the present disclosure are not limited thereto. For example, one or more other transistors and one or more capacitors may be included in the micro driver (µDriver). For example, 2T1C, 3T1C, 4T1C, 5T1C, 3T2C, 4T2C, 5T2C, 6T2C, 7T1C, 7T2C, 8T2C 8T2C structures, etc. are also possible for the micro driver (µDriver).

For example, a high potential power voltage VDD is applied to a first electrode of the driving transistor T_{DR} and a first electrode of the emission transistor T_{EM} is connected to a second electrode of the driving transistor T_{DR}, and a scan signal SC may be applied to a gate electrode of the driving transistor T_{DR}. The scan signal SC applied to the gate electrode of the driving transistor T_{DR} is a direct current (DC) power and a fixed reference voltage may be applied in every frame, but the exemplary embodiments of the present disclosure are not limited thereto.

The second electrode of the driving transistor T_{DR} is connected to a first electrode of the emission transistor T_{EM}, the micro LED (ED) is connected to a second electrode of the emission transistor T_{EM}, and the emission signal EM may be applied to a gate electrode of the emission transistor T_{EM}. The emission signal EM applied to the gate electrode of the emission transistor T_{EM} may be a pulse width modulation signal which changes in every frame, but the exemplary embodiments of the present disclosure are not limited thereto.

A first electrode of the micro LED (ED) is connected to the second electrode of the emission transistor T_{EM} and a second electrode thereof may be connected to the ground. For example, the first electrode is an anode electrode and the second electrode may be a cathode electrode, but the exemplary embodiments of the present disclosure are not limited thereto.

Each of the driving transistor T_{DR} and the emission transistor T_{EM} may be an n-type transistor or a p-type transistor.

The driving transistor T_{DR} is turned on by a scan signal SC applied from the timing controller T-CON or the driving IC such as the gate driving IC to the micro driver (µDriver) and the emission transistor T_{EM} is turned on by the emission signal EM. By doing this, the driving current is applied to the micro LED (ED) via the driving transistor T_{DR} and the emission transistor T_{EM} by the high potential power voltage VDD applied to the first electrode of the driving transistor T_{DR} so that the micro LED (ED) may emit light.

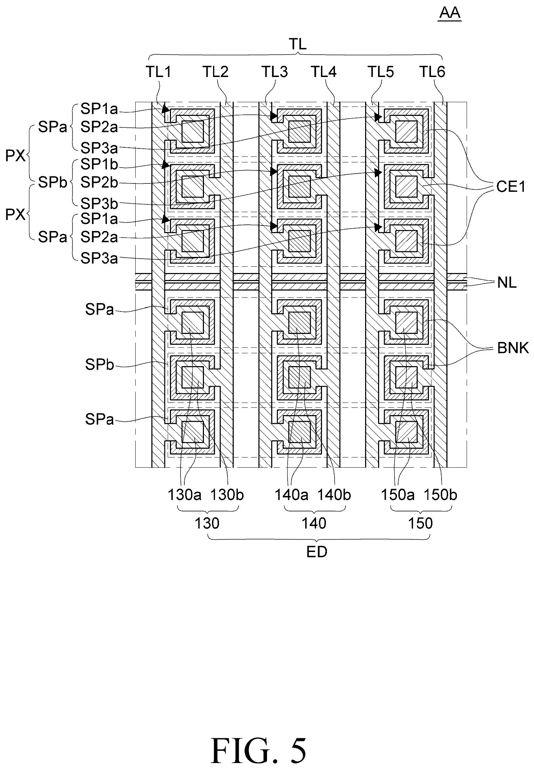

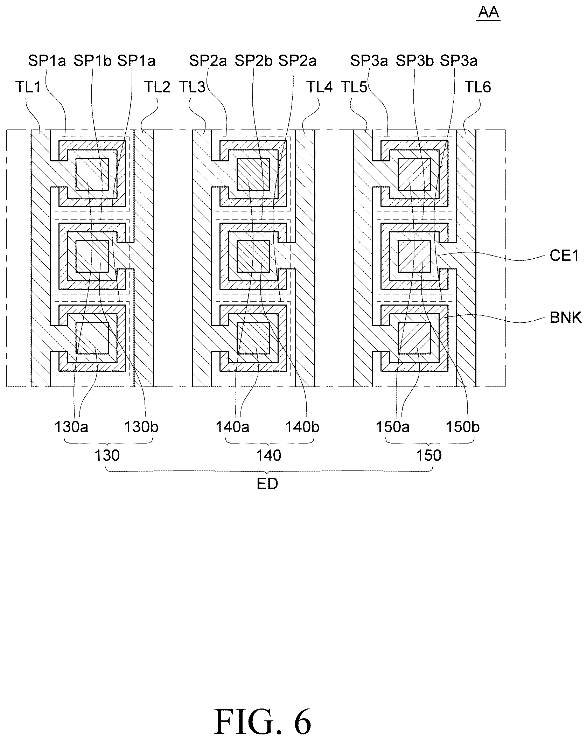

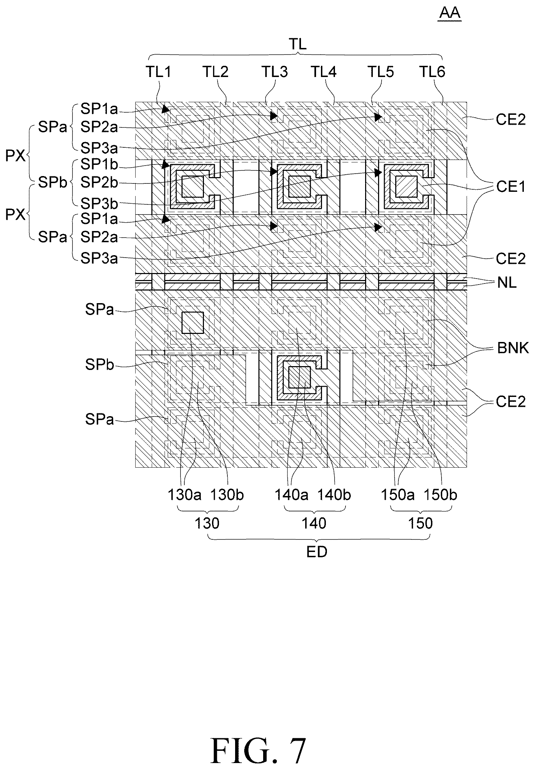

FIGS. 5 to 7 are top plan views of a display device according to an embodiment of the present disclosure. For example, FIG. 5 is an enlarged top plan view of a display area including a plurality of pixels PX. For example, FIG. 6 is an enlarged top plan view of the display area including the pair of pixels PX. For example, FIG. 7 is an enlarged top plan view of the display area including the plurality of pixels PX. FIGS. 5 and 6 illustrate only a plurality of signal lines TL, a plurality of communication lines NL, a plurality of first electrodes CE1, a plurality of banks BNK, and a plurality of micro-LEDs ED. However, the embodiments of the present disclosure are not limited thereto. FIG. 7 is an enlarged top plan view illustrating a state in which a plurality of second electrodes CE2 are additionally disposed in FIG. 5.

Referring to FIGS. 5 and 6, a plurality of pixels PX each of which is configured by a plurality of sub pixels may be disposed in the active area AA. Each of the plurality of sub pixels includes a micro LED (ED) and may independently emit light. The plurality of sub pixels may be disposed in a matrix by forming a plurality of rows and a plurality of columns, but the exemplary embodiments of the present disclosure are not limited thereto.

A plurality of sub pixels may include a plurality of main sub pixels SPa and a plurality of redundancy sub pixels SPb. For example, the plurality of main sub pixels SPa may be sub pixels mainly used when a display device 1000 operates. The plurality of redundancy sub pixels SPb may be extra sub pixels used when the plurality of main sub pixels SPa are defective.

The plurality of main sub pixels SPa may include a first main sub pixel SP1a, a second main sub pixel SP2a, and a third main sub pixel SP3a. For example, any one of the first main sub pixel SP1a, the second main sub pixel SP2a, and the third main sub pixel SP3a may be a red sub pixel, another main sub pixel may be a green sub pixel, and/or the other main sub pixel may be a blue sub pixel. However, the present disclosure is not limited thereto. In another example, each of the main sub pixels may be a white sub pixel. The types of plurality of sub pixels are illustrative. However, the embodiments of the present disclosure are not limited thereto. For example, the plurality of main sub pixels SPa may include more or less main sub pixels depending on the arrangment manner of the pixels.

The plurality of redundancy sub pixels SPb may include a first redundancy sub pixel SP1b, a second redundancy sub pixel SP2b, and a third redundancy sub pixel SP3b. For example, any one of the first redundancy sub pixel SP1b, the second redundancy sub pixel SP2b, and the third redundancy sub pixel SP3b may be a red sub pixel, another redundancy sub pixel may be a green sub pixel, and the other redundancy sub pixel may be a blue sub pixel. The types of plurality of sub pixels are illustrative. However, the embodiments of the present disclosure are not limited thereto. For example, the plurality of redundancy sub pixels SPb may include more or less redundancy sub pixels depending on the arrangment manner of the pixels.

The first main sub pixel SP1a and the first redundancy sub pixel SP1b may emit light beams with the same color, the second main sub pixel SP2a and the second redundancy sub pixel SP2b may emit light beams with the same color, and the third main sub pixel SP3a and the third redundancy sub pixel SP3b may emit light beams with the same color. However, the embodiments of the present disclosure are not limited thereto.

The plurality of main sub pixels SPa may be disposed in a plurality of rows, and the plurality of redundancy sub pixels SPb may be disposed in a plurality of rows. The rows in which the plurality of redundancy sub pixels SPb are disposed may be disposed between the pair of rows in which the plurality of main sub pixels SPa is disposed. For example, the plurality of main sub pixels SPa may be disposed in an n-th row, the plurality of redundancy sub pixels SPb may be disposed in an (n+1)th row, and the plurality of main sub pixels SPa may be disposed in an (n+2)th row. Further, the plurality of main sub pixels SPa may be disposed in an (n+3)th row and an (n+5)th row, and the plurality of redundancy sub pixels SPb may be disposed in an (n+4)th row. The plurality of redundancy sub pixels SPb may be disposed between the pair of main sub pixels SPa disposed in different rows. In other words, the arrangement or structure of one row of redundancy sub pixels SPb interposed between two rows of main sub pixels SPa may be repeated disposed in a portion or all of the display panel. Alternatively, when the plurality of main sub pixels SPa may be disposed in a plurality of columns, the plurality of redundancy sub pixels SPb may be disposed in columns while interposed between two columns of main sub pixels Spa respectively.

The plurality of pixels PX may each include the plurality of main sub pixels SPa. For example, one pixel PX may include one first main sub pixel SP1a, one second main sub pixel SP2a, and one third main sub pixel SP3a. However, the embodiments of the present disclosure are not limited thereto. The first main sub pixel SP1a, the second main sub pixel SP2a, and the third main sub pixel SP3a included in one pixel PX may be sequentially disposed in a row direction or a column direction. One pixel PX may include the first main sub pixel SP1a, the second main sub pixel SP2a, and the third main sub pixel SP3a and display images with various colors including red, green, blue, and white colors.

The plurality of pixels PX may share the plurality of redundancy sub pixels SPb. The two pixels PX disposed adjacent to each other may share the plurality of redundancy sub pixels SPb. The pair of pixels PX, which are disposed adjacent to each other in a column direction, may share the plurality of redundancy sub pixels SPb. For example, one first redundancy sub pixel SP1b, one second redundancy sub pixel SP2b, and one third redundancy sub pixel SP3b may be included in each of the two pixels PX adjacent to each other in the column direction. For example, the pixel PX including the plurality of main sub pixels SPa disposed in the n-th row may include the plurality of redundancy sub pixels SPb disposed in the (n+1)th row, and the pixel PX including the plurality of main sub pixels SPa disposed in the (n+2)th row may also include the plurality of redundancy sub pixels SPb disposed in the (n+1)th row. In other words, the plurality of redundancy sub pixels SPb disposed in the (n+1)th row is included in both of two pixels (referred to as one pair of pixels) adjacent to each other. Therefore, the plurality of redundancy sub pixels SPb may each be used for any one of the pair of pixels PX.

Each of the plurality of redundancy sub pixels SPb may be used instead of a corresponding one of the plurality of main sub pixels SPa included in the pair of pixels PX when any one of the plurality of main sub pixels SPa is defective. For example, the main sub pixel SPa may be defective because of various reasons such as defective connection between the main micro-LED ED and the first electrode CE1 caused by an alignment error, a defect of the main micro-LED ED, or a non-transfer defect of the main micro-LED ED when the plurality of main micro-LEDs ED are transfer to the plurality of main sub pixels SPa. Because the defective main sub pixel SPa cannot be normally operated when the display device 1000 operates, the redundancy sub pixel SPb may be used instead of the defective main sub pixel SPa.

For example, in case that the first main sub pixel SP1a is defective in the pixel PX including the first main sub pixel SP1a, the second main sub pixel SP2a, and the third main sub pixel SP3a disposed in the n-th row, the first redundancy sub pixel SP1b disposed in the (n+1)th row may be used instead of the defective first main sub pixel SP1a.

In another example, in case that the first main sub pixel SP1a is defective in the pixel PX including the first main sub pixel SP1a, the second main sub pixel SP2a, and the third main sub pixel SP3a disposed in the n-th row and the third main sub pixel SP3a is defective in the pixel PX including the first main sub pixel SP1a, the second main sub pixel SP2a, and the third main sub pixel SP3a disposed in the (n+2)th row, the first redundancy sub pixel SP1b disposed in the (n+1)th row may be used instead of the defective first main sub pixel SP1a disposed in the n-th row, and the third redundancy sub pixel SP3b disposed in the (n+1)th row may be used instead of the defective third main sub pixel SP3a disposed in the (n+2)th row. In this case, one of the pair of pixels PX may be configured to emit light by a combination of the first redundancy sub pixel SP1b disposed in the (n+1)th row and the second main sub pixel SP2a and the third main sub pixel SP3a disposed in the n-th row, and the remaining one of the pair of pixels PX may be configured to emit light by a combination of the first main sub pixel SP1a and the second main sub pixel SP2a disposed in the (n+2)th row and the third redundancy sub pixel SP3b disposed in the (n+1)th row.

Therefore, on the basis of whether the plurality of main sub pixels SPa is defective, the pixel PX may operate by a combination of the main sub pixels SPa or operate by a combination of the main sub pixel SPa and the redundancy sub pixel SPb. For example, some of the plurality of pixels PX may display images only by a combination of the plurality of main sub pixels SPa, and some of the remaining pixels PX may display images by a combination of one or more main sub pixels SPa and one or more redundancy sub pixels SPb.

Next, the plurality of signal lines TL may be disposed in an area between the plurality of sub pixels. The plurality of signal lines TL may extend in the column direction between the plurality of sub pixels. The plurality of signal lines TL may be wiring lines which transmit an anode voltage from the pixel drive circuit PD to the plurality of sub pixels. For example, the plurality of signal lines TL may be electrically connected to the plurality of pixel drive circuits PD and the first electrodes CE1 of the plurality of sub pixels. The anode voltage output from the pixel drive circuit PD may be transmitted to the first electrode CE1 of the plurality of sub pixels through the plurality of signal lines TL. For example, the first electrode CE1 may be an electrode which is electrically connected to the anode electrode of the micro LED (ED). Therefore, the anode voltage from the signal line TL may be transmitted to the anode electrode of the micro LED (ED) through the first electrode CE1.

Accordingly, instead of the plurality of transistors and storage capacitors formed in each of the plurality of sub pixels, a pixel drive circuit PD in which a plurality of pixel circuits is integrated is used to simplify the structure of the display device 1000. Further, a circuit which is disposed in each of the plurality of sub pixels is integrated into one pixel drive circuit PD so that highly efficient low power driving is possible.

The plurality of signal lines TL may include a first signal line TL1, a second signal line TL2, a third signal line TL3, a fourth signal line TL4, a fifth signal line TL5, and a sixth signal line TL6. The first signal line TL1 may be electrically connected to the plurality of first main sub pixels SP1a, and the second signal line TL2 may be electrically connected to the plurality of first redundancy sub pixels SP1b. The third signal line TL3 may be electrically connected to the plurality of second main sub pixels SP2a, and the fourth signal line TL4 may be electrically connected to the plurality of second redundancy sub pixels SP2b. The fifth signal line TL5 may be electrically connected to the plurality of third main sub pixels SP3a, and the sixth signal line TL6 may be electrically connected to the plurality of third redundancy sub pixels SP3b. In this case, the first signal line TL1, the third signal line TL3 and the fifth signal line TL5 may be electrically connected to the plurality of main sub pixels SPa, and the second signal line TL2, the fourth signal line TL4 and the sixth signal line TL6 may be electrically connected to the plurality of redundancy sub pixels SPb, such that the signal lines connected to the main sub pixel and the signal lines connected to the redundancy sub pixels are separated from each other and alternately arranged in the row direction.

The plurality of first main sub pixels SP1a and the plurality of first redundancy sub pixels SP1b may be disposed between the first signal line TL1 and the second signal line TL2. The first signal line TL1 may be disposed at one side of the plurality of first main sub pixels SP1a and one side of the plurality of first redundancy sub pixels SP1b, and the second signal line TL2 may be disposed at the other side of the plurality of first main sub pixels SP1a and the other side of the plurality of first redundancy sub pixels SP1b. The plurality of second main sub pixels SP2a and the plurality of second redundancy sub pixels SP2b may be disposed between the third signal line TL3 and the fourth signal line TL4. For example, the third signal line TL3 may be disposed adjacent to the second signal line TL2. For example, the third signal line TL3 may be disposed at one side of the plurality of second main sub pixels SP2a and one side of the plurality of second redundancy sub pixels SP2b, and the fourth signal line TL4 may be disposed at the other side of the plurality of second main sub pixels SP2a and the other side of the plurality of second redundancy sub pixels SP2b. The plurality of third main sub pixels SP3a and the plurality of third redundancy sub pixels SP3b may be disposed between the fifth signal line TL5 and the sixth signal line TL6. For example, the fourth signal line TL4 may be disposed adjacent to the fifth signal line TL5. For example, the fifth signal line TL5 may be disposed at one side of the plurality of third main sub pixels SP3a and one side of the plurality of third redundancy sub pixels SP3b, and the sixth signal line TL6 may be disposed at the other side of the plurality of third main sub pixels SP3a and the other side of the plurality of third redundancy sub pixels SP3b.

The plurality of signal lines TL may be formed of a conductive material. For example, the plurality of signal lines TL may include a conductive material, such as titanium (Ti), aluminum (Al), copper (Cu), molybdenum (Mo), nickel (Ni), chrome (Cr), indium tin oxide (ITO), indium zinc oxide (IZO), indium gallium zinc oxide (IGZO). However, the exemplary embodiments of the present disclosure are not limited thereto. As another example, the plurality of signal lines TL may be formed with a multi-layered structure of conductive materials. For example, the plurality of signal lines TL may be formed with a multi-layered structure of titanium (Ti)/aluminum (Al)/titanium (Ti)/indium tin oxide (ITO), but the exemplary embodiments of the present disclosure are not limited thereto.

A plurality of communication lines NL may be disposed in an area between the plurality of pixels PX. The plurality of communication lines NL may be disposed to extend in the row direction in an area between the plurality of pixels PX. The plurality of communication lines NL is disposed in the area between the plurality of second electrodes CE2 and does not overlap the plurality of second electrodes CE2. For example, the plurality of communication lines NL may be wiring lines used for short distance communication, such as near field communication (NFC). The plurality of communication lines NL may serve as antennas. For example, the plurality of communication lines NL may be a plurality of connection lines, but the exemplary embodiments of the present disclosure are not limited thereto.

According to the present disclosure, a bank BNK may be disposed in each of the plurality of sub pixels. The plurality of banks BNK may be structures in which the plurality of micro LEDs (ED) is seated. The plurality of banks BNK may guide a position of the plurality of micro LEDs (ED) during a transfer process of transferring the plurality of micro LEDs (ED) to the display device 1000. The plurality of micro LEDs (ED) may be transferred onto the plurality of banks BNK in the transfer process of the plurality of micro LEDs (ED). The plurality of banks BNK may be a bank pattern or a structure, but the exemplary embodiments of the present disclosure are not limited thereto.

The banks BNK of the plurality of sub pixels may be disposed adjacent to one another. The bank BNK of the first main sub pixel SP1a, the bank BNK of the second main sub pixel SP2a, the bank BNK of the third main sub pixel SP3a, the bank BNK of the first redundancy sub pixel SP1b, the bank BNK of the second redundancy sub pixel SP2b, and the bank BNK of the third redundancy sub pixel SP3b may be configured to be separated from one another. Therefore, the banks BNK of the first main sub pixel SP1a, the second main sub pixel SP2a, and the third main sub pixel SP3a, to which different types of micro-LEDs ED are transferred, may be easily identified. In addition, the banks BNK of the first redundancy sub pixel SP1b, the second redundancy sub pixel SP2b, and the third redundancy sub pixel SP3b, to which different types of micro-LEDs ED are transferred, may be easily identified.

For example, the plurality of banks BNK may be formed of an organic insulating material. The plurality of banks BNK is configured by a single layer or a double layer of an organic insulating material. For example, the plurality of banks BNK includes a photo resist, polyimide (PI), or acrylic-based material, but the exemplary embodiments of the present disclosure are not limited thereto.

The first electrode CE1 may be disposed in each of the plurality of sub pixels. The first electrode CE1 may be disposed on the bank BNK. The first electrode CE1 may be electrically connected to one signal line TL, among the plurality of signal lines TL, and thus may also be referred to as first connection electrode. At least a part of the first electrode CE1 extends to the outside of the bank BNK to be electrically connected to the signal line TL which is the most adjacent to the first electrode CE1. For example, a part of the first electrode CE1 of the 1-1-th sub pixel SP1a extends to one area of the 1-1-th sub pixel SP1a to be electrically connected to the first signal line TL1. A part of the first electrode CE1 of the 1-2-th sub pixel SP1b extends to the other area of the 1-2-th sub pixel SP1b to be electrically connected to the second signal line TL2. A part of the first electrode CE1 of the 2-1-th sub pixel SP2a extends to one area of the 2-1-th sub pixel SP2a to be electrically connected to the third signal line TL3. A part of the first electrode CE1 of the 2-2-th sub pixel SP2b extends to the other area of the 2-2-th sub pixel SP2b to be electrically connected to the fourth signal line TL4. A part of the first electrode CE1 of the 3-1-th sub pixel SP3a extends to one area of the 3-1-th sub pixel SP3a to be electrically connected to the fifth signal line TL5. A part of the first electrode CE1 of the 3-2-th sub pixel SP3b extends to the other area of the 3-2-th sub pixel SP3b to be electrically connected to the sixth signal line TL6. As shown in FIG. 5, the parts of the first electrodes CE1 of each of the sub pixels SP1a in different rows, the sub pixels SP2a in different rows and the sub pixels SP3a in different rows may be aligned with each other in the column direction so as to be electrically connected to a same signal line. Similarly, the parts of the first electrodes CE1 of each of the sub pixels SP1b in different rows, the sub pixels SP2b in different rows and the sub pixels SP3b in different rows may be aligned with each other in the column direction so as to be electrically connected to a same signal line.

The first electrode CE1 is electrically connected to the anode electrode of the micro LED (ED) and may transmit an anode voltage from the pixel drive circuit PD to the micro LED (ED) through the signal line TL. Different voltages may be applied to the first electrodes CE1 of the plurality of sub pixels depending on the image to be displayed. For example, different voltages may be applied to the first electrodes CE1 of the plurality of sub pixels. Therefore, the first electrode CE1 may be a pixel electrode, but the exemplary embodiments of the present disclosure are not limited thereto.

The first electrode CE1 may include a conductive material. For example, the first electrode CE1 may be integrally formed with the plurality of signal lines TL. For example, the first electrode CE1 may include the same conductive material as the plurality of signal lines TL, but the exemplary embodiments of the present disclosure are not limited thereto. For example, the first electrode CE1 may include a conductive material, such as titanium (Ti), aluminum (Al), copper (Cu), molybdenum (Mo), nickel (Ni), chrome (Cr), indium tin oxide (ITO), indium zinc oxide (IZO), indium gallium zinc oxide (IGZO). However, the exemplary embodiments of the present disclosure are not limited thereto. As another example, the first electrode CE1 may include a multi-layered structure of conductive materials. For example, the plurality of first electrodes CE1 may include a multi-layered structure of titanium (Ti)/aluminum (Al)/titanium (Ti)/indium tin oxide (ITO), but the exemplary embodiments of the present disclosure are not limited thereto.

The micro LED (ED) may be disposed in each of the plurality of sub pixels. The plurality of micro LEDs (ED) may be disposed on the bank BNK and the first electrode CE1. The plurality of micro LEDs (ED) is disposed on the first electrode CE1 and is electrically connected to the first electrode CE1. Accordingly, the micro LED (ED) is applied with an anode voltage from the pixel drive circuit PD through the signal line TL and the first electrode CE1 to emit light.

The plurality of micro-LEDs ED may include first micro-LEDs 130, second micro-LEDs 140, and third micro-LEDs 150. The first micro-LEDs 130 may be disposed in the first main sub pixel SP1a and the first redundancy sub pixel SP1b. The second micro-LEDs 140 may be disposed in the second main sub pixel SP2a and the second redundancy sub pixel SP2b. The third micro-LEDs 150 may be disposed in the third main sub pixel SP3a and the third redundancy sub pixel SP3b. For example, any one of the first micro-LED 130, the second micro-LED 140, and the third micro-LED 150 may be a red micro-LED, another micro-LED may be a green micro-LED, the other micro-LED may be a blue micro-LED. However, the embodiments of the present disclosure are not limited thereto. Therefore, light beams with various colors including the white color may be implemented by combining red light, green light, and blue light emitted from the plurality of micro-LEDs ED. The types of micro-LEDs ED are illustrative. However, the embodiments of the present disclosure are not limited thereto.

The first micro-LEDs 130 may include a first main micro-LED 130a disposed in the first main sub pixel SP1a, and a first redundancy micro-LED 130b disposed in the first redundancy sub pixel SP1b. The second micro-LEDs 140 may include a second main micro-LED 140a disposed in the second main sub pixel SP2a, and a second redundancy micro-LED 140b disposed in the second redundancy sub pixel SP2b. The third micro-LEDs 150 may include a third main micro-LED 150a disposed in the third main sub pixel SP3a, and a third redundancy micro-LED 150b disposed in the third redundancy sub pixel SP3b.

In this case, the plurality of pixels PX may display images with various colors by a combination of one of the first main micro-LED 130a and the first redundancy micro-LED 130b, one of the second main micro-LED 140a and the second redundancy micro-LED 140b, and one of the third main micro-LED 150a and the third redundancy micro-LED 150b. For example, some of the plurality of pixels PX may each display images by operating the first main micro-LED 130a, and some of the remaining pixels PX may each display images by operating the first redundancy micro-LED 130b. Some of the other pixels PX may each display images by operating the second main micro-LED 140a, and some of the remaining pixels PX may each display images by operating the second redundancy micro-LED 140b. Some of the other pixels PX may each display images by operating the third main micro-LED 150a, and some of the remaining pixels PX may each display images by operating the third redundancy micro-LED 150b.

In addition, in case that the micro-LEDs ED are used, a display panel 100 may be manufactured by forming the plurality of micro-LEDs on a wafer and transferring the micro-LEDs to a substrate 110 of the display panel 100. However, various types of defects may occur during a process of transferring the plurality of micro-LEDs ED having fine sizes to the substrate 110. For example, a non-transfer defect, which is caused when the micro-LEDs ED are not transferred, may occur in some of the sub pixels, and a defect, in which the micro-LEDs ED are transferred while deviating from exact positions, may occur because of alignment errors in some of the sub pixels. In addition, the transferred micro-LED ED may be defective even though the transfer process is normally performed. Therefore, the plurality of (for example, two or one pair of ) micro-LEDs ED of the same type may be transferred to one sub pixel in consideration of defects occurring during the process of transferring the plurality of micro-LEDs ED. Further, a lighting inspection may be performed on the plurality of micro-LEDs ED, and only one micro-LED ED, which is finally determined as being normal, may be used.

For example, the first main micro-LED 130a, the first redundancy micro-LED 130b, the second main micro-LED 140a, the second redundancy micro-LED 140b, the third main micro-LED 150a, and the third redundancy micro-LED 150b may be transferred to one pixel PX, and whether these LEDs are defective may be inspected. If all the first main micro-LED 130a, the second main micro-LED 140a, and the third main micro-LED 150a are determined as being normal, the first redundancy micro-LED 130b, the second redundancy micro-LED 140b, and the third redundancy micro-LED 150b may not be used. In another example, in case that the first main micro-LED 130a is determined as being defective among the first main micro-LED 130a, the second main micro-LED 140a, and the third main micro-LED 150a, the first redundancy micro-LED 130b may be used instead of the first main micro-LED 130a. In still another example, in case that the second main micro-LED 140a is not transferred among the first main micro-LED 130a, the second main micro-LED 140a, and the third main micro-LED 150a, the second redundancy micro-LED 140b may be used instead of the non-transferred second main micro-LED 140a.

Only one micro-LED ED may be finally used even though the plurality of micro-LEDs ED of the same type is transmitted to one pixel PX. In this case, any one of the pair of micro-LEDs ED may be the main (main or primary) micro-LED ED, as described above, and the other of the micro-LEDs ED may be the redundancy micro-LED ED. The redundancy micro-LED ED may be an extra micro-LED ED transferred to prepare for a defect of the main micro-LED ED. When the main micro-LED ED is defective, the redundancy micro-LED ED may be used instead of the main micro-LED ED. When the main micro-LED ED is defective, the redundancy micro-LED ED may be additionally transferred, which may minimize or reduce a deterioration in display quality caused by a defect of the main micro-LED ED. For example, the first main micro-LED 130a, the second main micro-LED 140a, and the third main micro-LED 150a may be used as the main micro-LEDs ED, and the first redundancy micro-LED 130b, the second redundancy micro-LED 140b, and the third redundancy micro-LED 150b may be used as the redundancy micro-LEDs ED.

Next, with reference to FIGS. 5 to 7 together, the second electrodes CE2 may be respectively disposed in the plurality of sub pixels. The second electrode CE2 may be disposed on the micro-LED ED. The second electrodes CE2 may be electrically connected to a pixel drive circuit PD through a plurality of contact electrodes CCE.

For example, the second electrode CE2 is electrically connected to the cathode electrode of the micro LED (ED) to transmit a cathode voltage to the micro LED (ED). The same cathode voltage may be applied to the second electrodes CE2 of the plurality of sub pixels. For example, the same voltage may be applied to the second electrode CE2 of each of the plurality of sub pixels and the cathode electrode of the micro LED (ED). Therefore, the second electrode CE2 may be a common electrode, but the exemplary embodiments of the present disclosure are not limited thereto.

At least some of the plurality of sub pixel may share the second electrode CE2. At least some of the second electrodes CE2 of the plurality of sub pixels may be electrically connected to each other. As the same voltage is applied to the second electrode CE2, the second electrodes CE2 of at least some of sub pixels are shared. For example, the second electrodes of at least some pixels PX, among the plurality of pixels PX disposed on the same row may be connected to each other. For example, one second electrode CE2 may be disposed in the plurality of pixels PX. One second electrode CE2 may be disposed in every n sub pixels.

For example, some of the second electrodes CE2 of the plurality of sub pixels may be spaced apart or separated from each other. For example, a second electrode CE2 connected to pixels PX in a n-th row and a second electrode CE2 connected to pixels PX in a n+1-th row may be spaced apart or separated from each other. For example, the plurality of second electrodes CE2 may be disposed to be spaced apart from each other with the plurality of communication lines NL extending in the row direction therebetween. Accordingly, the number of the plurality of sub pixels may be larger than the number of the plurality of second electrodes CE2. As another example, all the second electrodes CE2 of the plurality of sub pixels are connected to each other so that only one second electrode CE2 may be disposed on the substrate 110, but the exemplary embodiments of the present disclosure are not limited thereto.

The plurality of second electrodes CE2 may include a transparent conductive material, but the exemplary embodiments of the present disclosure are not limited thereto. The plurality of second electrodes CE2 may include a transparent conductive material so that light emitted from the micro LED (ED) may travel toward the top of the second electrode CE2. For example, the second electrode CE2 may include a transparent conductive material, such as indium tin oxide (ITO), indium zinc oxide (IZO), indium gallium zinc oxide (IGZO), but the exemplary embodiments of the present disclosure are not limited thereto.

A plurality of contact electrodes CCE may be disposed on the substrate 110. For example, the plurality of contact electrodes CCE may be disposed to be spaced apart from the plurality of banks BNK and the plurality of signal lines TL. Each of the plurality of second electrodes CE2 may overlap at least one contact electrode CCE. For example, one second electrode CE2 may overlap a plurality of contact electrodes CCE.

For example, the plurality of contact electrodes CCE may be electrically connected to the plurality of second electrodes CE2. The plurality of contact electrodes CCE is disposed between the substrate 110 and the plurality of second electrodes CE2 to transmit a cathode voltage from the pixel drive circuit PD to the second electrode CE2.

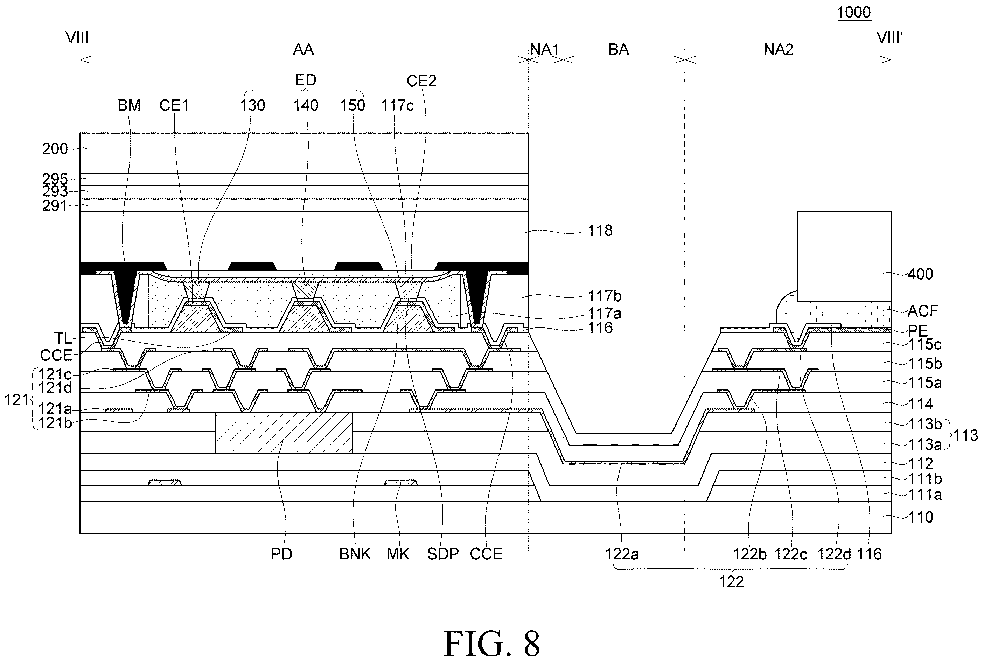

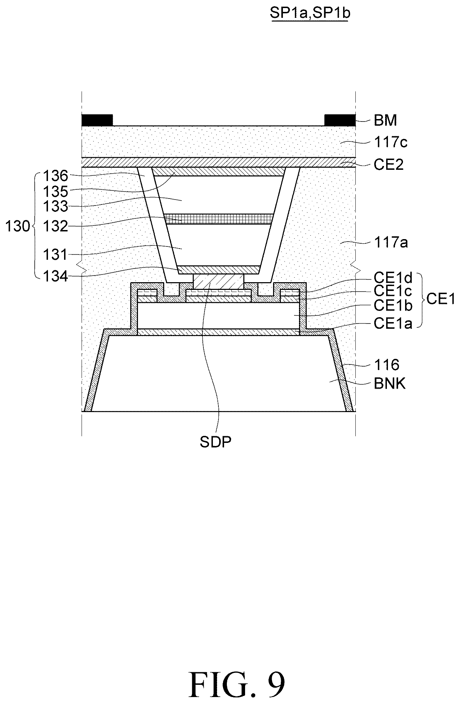

Hereinafter, a cross-sectional structure of the sub pixel of the display panel 100 according to the embodiment of the present disclosure will be described with reference to FIGS. 8 and 9.

FIG. 8 is a cross-sectional view of the display device according to the embodiment of the present disclosure. FIG. 9 is a cross-sectional view of the display device according to the embodiment of the present disclosure. For example, FIG. 8 is a cross-sectional view taken along line VIII-VIII' in FIG. 3, e.g., a cross-sectional view illustrating a display area AA, a first non-display area NA1, a bending area BA, and a second non-display area NA2. For example, FIG. 9 is an enlarged cross-sectional view illustrating the first main sub pixel SP1a or the first redundancy sub pixel SP1b.

Referring to FIG. 9, a first buffer layer 111a and a second buffer layer 111b may be disposed in the remaining area of the substrate 110 excluding the bending area BA.

The first buffer layer 111a and the second buffer layer 111b may be disposed in the active area AA, the first non-active area NA1, and the second non-active area NA2. The first buffer layer 111a and the second buffer layer 111b may reduce permeation of moisture or impurities through the substrate 110. The first buffer layer 111a and the second buffer layer 111b may be formed of an inorganic insulating material. For example, the first buffer layer 111a and the second buffer layer 111b may include a single layer or a plurality of layers of silicon oxide (SiOx) or silicon nitride (SiNx), but the exemplary embodiments of the present disclosure are not limited thereto.

For example, the first buffer layer 111a and the second buffer layer 111b on the bending area BA may be partially removed. A top surface of the substrate 110 located in the bending area BA may be exposed from the first buffer layer 111a and the second buffer layer 111b. The first buffer layer 111a and the second buffer layer 111b which are formed of an inorganic insulating material are removed from the bending area BA to minimize or reduce cracks of the first buffer layer 111a and the second buffer layer 111b which may be generated during the bending.

A plurality of alignment keys MK may be disposed between the first buffer layer 111a and the second buffer layer 111b. The plurality of alignment keys MK may be configured to identify a position of the pixel drive circuit PD during the manufacturing process of the display device 1000. For example, the plurality of alignment keys MK may be configured to align a position of the pixel drive circuit PD which is transferred onto the adhesive layer 112. As another example, the plurality of alignment keys MK may be omitted.

The adhesive layer 112 may be disposed on the second buffer layer 111b. The adhesive layer 112 may be disposed in the active area AA, the first non-active area NA1, the bending area BA, and the second non-active area NA2. For example, the adhesive layer 112 may be disposed on the second buffer layer 111b in the display area AA, the first non-display area NA1, and the second non-display area NA2, and on the substrate 110 in the bending area BA, without being limited thereto. As another example, in the non-active area NA including the bending area BA, at least a part of the adhesive layer 112 may be removed. For example, the adhesive layer 112 may be formed of any one of adhesive polymer, epoxy resin, UV curable resin, polyimide based, acrylate based, urethane based, and polydimethylsiloxane (PDMS), but the exemplary embodiments of the present disclosure are not limited thereto.

The pixel drive circuit PD may be disposed on the adhesive layer 112 in the active area AA. When the pixel drive circuit PD is implemented as a driving driver, the driving driver may be mounted on the adhesive layer 112 by the transfer process, but the exemplary embodiments of the present disclosure are not limited thereto.

A protection layer 113 may be disposed on the adhesive layer 112 and the pixel drive circuit PD. The protection layer 113 may be disposed so as to enclose or at least partially surround the pixel drive circuit PD, but the exemplary embodiments of the present disclosure are not limited thereto. For example, the protection layer 113 may be disposed so as to cover at least a part of a side surface of the pixel drive circuit PD. As another example, the protection layer 113 may be disposed so as to cover at least a part of a top surface of the pixel drive circuit PD.

The protection layer 113 may include one or more organic insulating layers. For example, the protection layer 113 may include a first protection layer 113a disposed on the adhesive layer 112 and a second protection layer 113b disposed on the first protection layer 113a. For example, the first protection layer 113a and the second protection layer 113b may be disposed so as to enclose or at least partially surround a side surface of the pixel drive circuit PD. For example, the second protection layer 113b may be disposed so as to cover at least a part of a top surface of the pixel drive circuit PD. For example, at least one of the first protection layer 113a and the second protection layer 113b of the protection layer 113 disposed on the bending area BA may be omitted. For example, the first protection layer 113a is entirely disposed in the active area AA and the non-active area NA and the second protection layer 113b may be partially disposed in the active area AA, the first non-active area NA1, and the second non-active area NA2. For example, a part of the second protection layer 113b in the bending area BA may be removed. However, the protection layer 113 may be formed by a single layer, but the exemplary embodiments of the present disclosure are not limited thereto.

Each of the first protection layer 113a and the second protection layer 113b of the protection layer may include an organic insulating material, but the exemplary embodiments of the present disclosure are not limited thereto. For example, the first protection layer 113a and the second protection layer 113b may include a photo resist, polyimide (PI), or photo acrylic-based material, but the exemplary embodiments of the present disclosure are not limited thereto. For example, the first protection layer 113a and the second protection layer 113b may be an overcoat layer or an insulating layer, but the exemplary embodiments of the present disclosure are not limited thereto.

According to the present disclosure, in the active area AA, the plurality of first connection lines 121 may be disposed on the second protection layer 113b. The plurality of first connection lines 121 may be wiring lines which electrically connect the pixel drive circuit PD to the other component. For example, the pixel drive circuit PD may be electrically connected to the plurality of signal lines TL and the plurality of contact electrodes CCE through the plurality of first connection lines 121. For example, the plurality of first connection lines 121 may include a 1-1-th connection line 121a, a 1-2-th connection line 121b, a 1-3-th connection line 121c, and a 1-4-th connection line 121d, but the exemplary embodiments of the present disclosure are not limited thereto. The connection lines described herein may also be referred to as line connection patterns.

For example, the plurality of 1-1-th connection lines 121a may be disposed on the second protection layer 113b. The plurality of 1-1-th connection lines 121a may be electrically connected to the pixel drive circuit PD. The plurality of 1-1-th connection lines 121a may transmit a voltage output from the pixel drive circuit PD to the first electrode CE1 or the second electrode CE2.

For example, an additional protection layer may be further disposed on the second protection layer 113b. For example, a third protection layer 114 may be further disposed on the second protection layer 113b. The third protection layer 114 may be entirely disposed in the active area AA and the non-active area NA. In the bending area BA, the third protection layer 114 may cover a side surface of the second protection layer 113b and the top surface of the first protection layer 113a. The third protection layer 114 may include an organic insulating material. For example, the third protection layer 114 may include a photo resist, polyimide (PI), or photo acrylic-based material, but the exemplary embodiments of the present disclosure are not limited thereto. For example, the first protection layer 113a, the second protection layer 113b, and the third protection layer 114 may include the same material, but the exemplary embodiments of the present disclosure are not limited thereto.

The plurality of 1-2-th connection lines 121b may be disposed on the third protection layer 114. The plurality of 1-2-th connection lines 121b may be indirectly or directly connected to the pixel drive circuit PD. For example, a part of the 1-2-th connection line 121b may be directly connected to the pixel drive circuit PD through a contact hole of the third protection layer 114. The other part of the 1-2-th connection line 121b may be electrically connected to the 1-1-th connection line 121a through the contact hole of the third protection layer 114. However, the exemplary embodiments of the present disclosure are not limited thereto. A voltage output from the pixel drive circuit PD may be transmitted to the first electrode CE1 or the second electrode CE2 through a connection line other than the plurality of 1-2-th connection lines 121b.

The first insulating layer 115a may be disposed on the plurality of 1-2-th connection lines 121b. The first insulating layer 115a may be entirely disposed in the active area AA and the non-active area NA, but the exemplary embodiments of the present disclosure are not limited thereto. The first insulating layer 115a may include an organic insulating material, but the exemplary embodiments of the present disclosure are not limited thereto. For example, the first insulating layer 115a may include a photo resist, polyimide (PI), or photo acrylic-based material, but the exemplary embodiments of the present disclosure are not limited thereto.

The plurality of 1-3-th connection lines 121c may be disposed on the first insulating layer 115a. The plurality of 1-3-th connection lines 121c may be electrically connected to the plurality of 1-2-th connection lines 121b. For example, the 1-3-th connection lines 121c may be electrically connected to the 1-2-th connection line 121b through a contact hole of the first insulating layer 115a.

The second insulating layer 115b may be disposed on the plurality of 1-3-th connection lines 121c. The second insulating layer 115b may be disposed in a remaining area excluding the bending area BA, but the exemplary embodiments of the present disclosure are not limited thereto. The second insulating layer 115b may be disposed in the active area AA, the first non-active area NA1, and the second non-active area NA2, but the exemplary embodiments of the present disclosure are not limited thereto. For example, a part of the second insulating layer 115b disposed in the bending area BA may be removed. The second insulating layer 115b may include an organic insulating material, but the exemplary embodiments of the present disclosure are not limited thereto. For example, the second insulating layer 115b includes a photo resist, polyimide (PI), or photo acrylic-based material, but the exemplary embodiments of the present disclosure are not limited thereto.

The plurality of 1-4-th connection lines 121d may be disposed on the second insulating layer 115b. The plurality of 1-4-th connection lines 121d may be electrically connected to the plurality of 1-3-th connection lines 121c. For example, the 1-4-th connection lines 121d may be electrically connected to the 1-3-th connection line 121c through a contact hole of the second insulating layer 115b.

According to the present disclosure, in the non-active area NA, the plurality of second connection lines 122 may be disposed on the second protection layer 113b. The plurality of second connection lines 122 may be wiring lines which transmit a signal transmitted from the flexible circuit board (or flexible film) 400 and the printed circuit board 160 (see FIG. 1) to the pad unit PAD to the pixel drive circuit PD of the active area AA. For example, the plurality of second connection lines 122 is electrically connected to the plurality of pad electrodes PE to be applied with a signal from the flexible circuit board (or flexible film) 400 and the printed circuit board.

For example, the plurality of second connection lines 122 extends toward the active area AA from the pad unit PAD to transmit a signal to the wiring line of the active area AA. In this case, the plurality of second connection lines 122 may serve as a link line LL. The plurality of second connection lines 122 may include a 2-1-th connection line 122a, a 2-2-th connection line 122b, a 2-3-th connection line 122c, and a 2-4-th connection line 122d.

The plurality of 2-1-th connection lines 122a may be disposed on the second protection layer 113b. The plurality of 2-1-th connection lines 122a may extend from the second non-active area NA2 to the bending area BA and the first non-active area NA1. The plurality of 2-1-th connection lines 122a may transmit a signal transmitted from the flexible circuit board (or flexible film) 400 and the printed circuit board 500 to the pad unit PAD to the pixel drive circuit PD of the active area AA. For example, the 2-1-th connection line 122a extends from the second non-active area NA2 to the first non-active area NA1 and may be electrically connected to any one of the 1-1-th connection line 121a, the 1-2-th connection line 121b, the 1-3-th connection line 121c, and the 1-4-th connection line 121d of the plurality of first connection lines 121. For example, the 2-1-th connection line 122a may be directly connected to the 1-1-th connection line 121a disposed on the same layer or may be connected to the 1-2-th connection line 121b disposed on a different layer through a contact hole of the third protection layer 114, but is not limited thereto.

The plurality of 2-2-th connection lines 122b may be disposed on the third protection layer 114. The plurality of 2-2-th connection lines 122b may be disposed in the second non-active area NA2. The 2-2-th connection line 122b may be electrically connected to the 2-1-th connection line 122a through the contact hole of the third protection layer 114. Accordingly, a signal from the flexible circuit board (or flexible film) 400 and the printed circuit board may be transmitted to the 2-1-th connection line 122a through the 2-2-th connection line 122b.

The 2-3-th connection lines 122c may be disposed on the first insulating layer 115a. The 2-3-th connection lines 122c may be disposed in the second non-active area NA2. The 2-3-th connection lines 122c may be electrically connected to the 2-2-th connection line 122b through a contact hole of the first insulating layer 115a. Accordingly, a signal from the flexible circuit board (or flexible film) 400 and the printed circuit board may be transmitted to the 2-1-th connection line 122a through the 2-3-th connection line 122c and the 2-2-th connection line 122b.

The 2-4-th connection lines 122d may be disposed on the second insulating layer 115b. The 2-4-th connection lines 122d may be disposed in the second non-active area NA2. The 2-4-th connection lines 122d may be electrically connected to the 2-3-th connection line 122c through a contact hole of the second insulating layer 115b. Accordingly, a signal from the flexible circuit board (or flexible film) 400 and the printed circuit board 500 may be transmitted to the 2-1-th connection line 122a through the 2-4-th connection line 122d, the 2-3-th connection line 122c, and the 2-2-th connection line 122b.

The plurality of first connection lines 121 and the plurality of second connection lines 122 may be formed of any one of a conductive material having excellent ductility or various conductive materials used for the active area AA. For example, the second connection line 122 which is partially disposed in the bending area BA may include a conductive material having excellent ductility, such as gold (Au), silver (Ag), or aluminum (Al), but the exemplary embodiments of the present disclosure are not limited thereto. As another example, the plurality of first connection lines 121 and the plurality of second connection lines 122 may include molybdenum (Mo), chrome (Cr), titanium (Ti), nickel (Ni), neodymium (Nd), copper (Cu), and an alloy of silver (Ag) and magnesium (Mg) or an alloy thereof, but the exemplary embodiments of the present disclosure are not limited thereto.

The third insulating layer 115c may be disposed on the plurality of first connection lines 121 and the plurality of second connection lines 122. The third insulating layer 115c may be disposed in a remaining area excluding the bending area BA, but the exemplary embodiments of the present disclosure are not limited thereto. The third insulating layer 115c may be disposed in the active area AA, the first non-active area NA1, and the second non-active area NA2. A part of the third insulating layer 115c disposed in the bending area BA may be removed. The third insulating layer 115c may include an organic insulating material, but the exemplary embodiments of the present disclosure are not limited thereto. For example, the third insulating layer 115c may include a photo resist, polyimide (PI), or photo acrylic-based material, but the exemplary embodiments of the present disclosure are not limited thereto.

A plurality of banks BNK may be disposed on the third insulating layer 115c in the active area AA. The plurality of banks BNK may be disposed so as to overlap each of the plurality of sub pixels. One or more same type micro LED (ED) may be disposed above each of the plurality of banks BNK.

A plurality of signal lines TL may be disposed on the third insulating layer 115c in the active area AA. The plurality of signal lines TL may be disposed in an area between the plurality of banks BNK. For example, the plurality of signal lines TL may be disposed to be adjacent to any one of the plurality of banks BNK.

A plurality of contact electrodes CCE may be disposed on the third insulating layer 115c in the active area AA. The plurality of contact electrodes CCE may supply a cathode voltage from the pixel drive circuit PD to the second electrode CE2.

The first electrode CE1 may be disposed on the bank BNK. For example, the first electrode CE1 may be disposed to extend toward the top of the bank BNK from the adjacent signal line TL. The first electrode CE1 may be disposed on the top surface of the bank BNK and the side surface of the bank BNK. For example, the first electrode CE1 may be disposed to extend from the signal line TL on the top surface of the third insulating layer 115c to the side surface of the bank BNK and the top surface of the bank BNK.

Referring to FIG. 9, the first electrode CE1 may include a plurality of conductive layers. For example, the first electrode CE1 may include a first conductive layer CE1a, a second conductive layer CE1b, a third conductive layer CE1c, and a fourth conductive layer CE1d, but the exemplary embodiments of the present disclosure are not limited thereto.

The first conductive layer CE1a may be disposed on the bank BNK. The second conductive layer CE1b may be disposed on the first conductive layer CE1a. The third conductive layer CE1c may be disposed on the second conductive layer CE1b. The fourth conductive layer CE1d may be disposed on the third conductive layer CE1c. For example, the first conductive layer CE1a, the second conductive layer CE1b, the third conductive layer CE1c, and the fourth conductive layer CE1d may include titanium (Ti), molybdenum (Mo), aluminum (Al), or titanium (Ti) and indium tin oxide (ITO), but the exemplary embodiments of the present disclosure are not limited thereto.

According to the present disclosure, some conductive layer having a good reflection efficiency, among a plurality of conductive layers which configures the first electrode CE1 may be configured as an alignment key for alignment of the micro LED (ED) and/or a reflective plate. For example, the second conductive layer CE1b, among the plurality of conductive layers of the first electrode CE1, may include a reflective material. For example, the second conductive layer CE1b may include aluminum (Al), but the exemplary embodiments of the present disclosure are not limited thereto. Therefore, the second conductive layer CE1b may be configured as a reflective plate. Further, the second conductive layer CE1b has a high reflection efficiency to be easily identified during the manufacturing process so that a position of the micro LED (ED) or a transfer position may be aligned based on the second conductive layer CE1b.

For example, in order to configure the second conductive layer CE1b as a reflective plate, the third conductive layer CE1c and the fourth conductive layer CE1d which cover the second conductive layer CE1b may be partially removed or etched. For example, a part of the third conductive layer CE1c and the fourth conductive layer CE1d disposed on the bank BNK is removed or etched to expose a top surface of the second conductive layer CE1b. For example, a center portion and an edge portion (or a boundary portion) of the third conductive layer CE1c and the fourth conductive layer CE1d in which a solder pattern SDP is disposed remains and the remaining portion excluding the portions may be removed. For example, an edge portion (or a boundary portion) of each of the third conductive layer CE1c formed of titanium (Ti) and the fourth conductive layer CE1d formed of indium tin oxide (ITO) may not be etched. Therefore, corrosion of another conductive layer of the first electrode CE1 caused by tetramethylammonium hydroxide (TMAH) solution which is used for the mask process of the first electrode CE1 may be suppressed.

According to the present disclosure, the first conductive layer CE1a and the third conductive layer CE1c may include titanium (Ti) or molybdenum (Mo). The second conductive layer CE1b may include aluminum (Al). The fourth conductive layer CE1d may include a transparent conductive oxide layer, such as indium tin oxide (ITO) or indium zinc oxide (IZO), which is adhesive to the solder pattern SPD, and has corrosion resistance and acid resistance. However, the exemplary embodiments of the present disclosure are not limited thereto.

The first conductive layer CE1a, the second conductive layer CE1b, the third conductive layer CE1c, and the fourth conductive layer CE1d are sequentially deposited, and then are subject to a photolithographic process and an etching process to be patterned. However, the exemplary embodiments of the present disclosure are not limited thereto.

According to the present disclosure, the signal line TL, the contact electrode CCE, and the pad electrode PE disposed on the same layer as the first electrode CE1 may include a plurality of layers of conductive materials, but the exemplary embodiment of the present disclosure are not limited thereto. For example, the signal line TL, the contact electrode CCE, and the pad electrode PE may be formed of same materials in a same mask process at the same time. For example, the signal line TL, the contact electrode CCE, and the pad electrode PE may be formed of a plurality of layers of indium tin oxide (ITO)/titanium (Ti)/aluminum (Al)/titanium (Ti), but the exemplary embodiments of the present disclosure are not limited thereto.

According to the present disclosure, in each of the plurality of sub pixels, the solder pattern SDP may be disposed on the first electrode CE1. The solder pattern SDP may bond the micro LED (ED) to the first electrode CE1. The solder pattern SDP may bond the first electrode CE1 and the anode electrode 134 of the micro LED (ED) to be electrically connected to each other. The first electrode CE1 and the micro LED (ED) may be electrically connected through eutectic bonding using the solder pattern SDP, but the exemplary embodiments of the present disclosure are not limited thereto. For example, when the solder pattern SDP includes indium (In) and the anode electrode 134 of the micro LED (ED) includes gold (Au), during the transfer process of the micro LED (ED), heat and pressure are applied to bond the solder pattern SDP and the anode electrode 134. The micro LED (ED) may be bonded to the solder pattern SDP and the first electrode CE1 using the eutectic bonding without a separate adhesive material. For example, the solder pattern SDP may include indium (Id), tin (Sn), or an alloy thereof, but the exemplary embodiments of the present disclosure are not limited thereto. For example, the solder pattern SDP may be a bonding pad or an adhesive pad, but the exemplary embodiments of the present disclosure are not limited thereto.

According to the present disclosure, the passivation layer 116 may be disposed on the plurality of signal lines TL, the plurality of first electrodes CE1, the plurality of contact electrodes CCE, and the third insulating layer 115c. For example, the passivation layer 116 may be disposed in the active area AA, the first non-active area NA1, and the second non-active area NA2. A part of the passivation layer 116 disposed in the bending area BA may be removed. A part of the passivation layer 116 which covers a plurality of pad electrodes PE in the second non-active area NA2 may be removed. The passivation layer 116 is disposed so as to cover the remaining area excluding the bending area BA, the plurality of pad electrodes PE, and the solder pattern SDP to reduce permeation of moisture or impurities entering the micro LED (ED). For example, the passivation layer 116 may include a single layer or a plurality of layers of silicon oxide (SiOx) or silicon nitride (SiNx), but the exemplary embodiments of the present disclosure are not limited thereto. For example, the passivation layer 116 may be a protection layer or an insulating layer, but the exemplary embodiments of the present disclosure are not limited thereto. For example, the passivation layer 116 may include a hole through which the solder pattern SDP is exposed.

In each of the plurality of sub pixels, the micro-LED ED may be disposed on a solder pattern SDP. The first main micro-LED 130a may be disposed in the first main sub pixel SP1a, and the first redundancy micro-LED 130b may be disposed in the first redundancy sub pixel SP1b. The second main micro-LED 140a may be disposed in the second main sub pixel SP2a, and the second redundancy micro-LED 140b may be disposed in the second redundancy sub pixel SP2b. The third main micro-LED 150a may be disposed in the third main sub pixel SP3a, and the third redundancy micro-LED 150b may be disposed in the third redundancy sub pixel SP3b.

The micro LED (ED) may be formed on a silicon wafer using metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE), or a sputtering method. However, the exemplary embodiments of the present disclosure are not limited thereto.

With reference to FIG. 9, the first micro-LEDs 130 disposed in the first main sub pixel SP1a and the first redundancy sub pixel SP1b may each include an anode electrode 134, a first semiconductor layer 131, an active layer 132, a second semiconductor layer 133, a cathode electrode 135, and an encapsulation film 136. However, the embodiments of the present disclosure are not limited thereto. For example, the first micro-LED 130 may not include the encapsulation film 136.

The first semiconductor layer 131 may be disposed on the solder pattern SDP. The second semiconductor layer 133 may be disposed on the first semiconductor layer 131. For example, the active layer 132 may be disposed on the first semiconductor layer 131, and the second semiconductor layer 133 may be disposed on the active layer 132.

For example, one of the first semiconductor layer 131 and the second semiconductor layer 133 may be implemented by a compound semiconductor, such as a III-V group or a II-VI group and may be doped with an impurity (or dopant). For example, one of the first semiconductor layer 131 and the second semiconductor layer 133 is an n-type impurity doped semiconductor layer and the other one is a p-type impurity doped semiconductor, but the exemplary embodiments of the present disclosure are not limited thereto. For example, one or more of the first semiconductor layer 131 and the second semiconductor layer 133 may be a layer in which n-type or p-type impurity is doped on a material, such as gallium nitride (GaN), gallium phosphide (GaP), gallium arsenide phosphide (GaAsP), aluminum gallium indium phosphide (AlGaInP), indium aluminum phosphide (InAlP), aluminum gallium nitride (AlGaN), aluminum indium nitride (AlInN), aluminum indium gallium nitride (AlInGaN), aluminum gallium arsenide (AlGaAs), or gallium arsenide (GaAs). However, the exemplary embodiments of the present disclosure are not limited thereto. For example, the n-type impurity may be silicon (Si), germanium (Ge), selenium (Se), carbon (C), tellurium (Te), or tin (Sn), but the exemplary embodiments of the present disclosure are not limited thereto. For example, the p-type impurity may be magnesium (Mg), zinc (Zn), calcium (Ca), strontium (Sr), barium (Ba), or beryllium (Be), but the exemplary embodiments of the present disclosure are not limited thereto.

For example, each of the first semiconductor layer 131 and the second semiconductor layer 133 may be a nitride semiconductor including an n-type impurity or a nitride semiconductor including a p-type impurity, but the exemplary embodiments of the present disclosure are not limited thereto. For example, the first semiconductor layer 131 may be a nitride semiconductor including a p-type impurity and the second semiconductor layer 133 may be a nitride semiconductor including an n-type impurity, but the exemplary embodiments of the present disclosure are not limited thereto.

The active layer 132 may be disposed between the first semiconductor layer 131 and the second semiconductor layer 133. The active layer 132 is supplied with holes and electrons from the first semiconductor layer 131 and the second semiconductor layer 133 to emit light. For example, the active layer 132 may include one of a single well structure, a multi-well structure, a signal quantum well structure, a multi-quantum well (MQW) structure, a quantum dot structure, and a quantum line structure, but the exemplary embodiments of the present disclosure are not limited thereto. For example, the active layer 132 may include indium gallium nitride (InGaN) or gallium nitride (GaN), but the exemplary embodiments of the present disclosure are not limited thereto.

As another example, the active layer 132 has a multi quantum well (MQW) structure having a well layer and a barrier layer with a band gap higher than the well layer. For example, in the active layer 132, InGaN is configured as a well layer and an AlGaN layer is configured as a barrier layer, but the exemplary embodiments of the present disclosure are not limited thereto.

The anode electrode 134 may be disposed between the first semiconductor layer 131 and the solder pattern SDP. For example, the anode electrode 134 may electrically connect the first semiconductor layer 131 and the first electrode CE1. The anode voltage output from the pixel drive circuit PD may be applied to the first semiconductor layer 131 through the signal line TL, the first electrode CE1, and the anode electrode 134. For example, the anode electrode 134 may include a conductive material which may form eutectic bonding with the solder pattern SDP, but the exemplary embodiments of the present disclosure are not limited thereto. For example, the anode electrode 134 may include gold (Au), tin (Sn), tungsten (W), silicon (Si), silver (Ag), titanium (Ti), iridium (Ir), chromium (Cr), indium (In), zinc (Zn), lead (Pb), nickel (Ni), platinum (Pt), and copper (Cu), or an alloy thereof, but the exemplary embodiments of the present disclosure are not limited thereto.

The cathode electrode 135 may be disposed on the second semiconductor layer 133. For example, the cathode electrode 135 may electrically connect the second semiconductor layer 133 and the second electrode CE2. A cathode voltage output from the pixel drive circuit PD may be applied to the second semiconductor layer 133 through the contact electrode CCE, the second electrode CE2, and the cathode electrode 135. The cathode electrode 135 may include a transparent conductive material to allow light emitted from the micro LED (ED) to be directed to the top of the micro LED (ED), but the exemplary embodiments of the present disclosure are not limited thereto. For example, the cathode electrode 135 may include a material, such as indium tin oxide (ITO), indium zinc oxide (IZO), indium gallium zinc oxide (IGZO), but the exemplary embodiments of the present disclosure are not limited thereto.

The encapsulation film 136 may be disposed in at least a part of the first semiconductor layer 131, the active layer 132, the second semiconductor layer 133, the anode electrode 134, and the cathode electrode 135. For example, the encapsulation film 136 may enclose or at least partially surround at least a part of the first semiconductor layer 131, the active layer 132, the second semiconductor layer 133, the anode electrode 134, and the cathode electrode 135, without being limited thereto. For example, the encapsulation film 136 may not be included in the micro LED (ED).

For example, the encapsulation film 136 may protect the first semiconductor layer 131, the active layer 132, and the second semiconductor layer 133. For example, the encapsulation film 136 may be disposed on a side surface of the first semiconductor layer 131, a side surface of the active layer 132, and a side surface of the second semiconductor layer 133.

For example, the encapsulation film 136 may be disposed on at least a part of the anode electrode 134 and the cathode electrode 135, for example, on an edge portion (or a boundary portion or one side) of the anode electrode 134 and an edge portion (or a boundary portion or one side) of the cathode electrode 135. At least a part of the anode electrode 134 is exposed from the encapsulation film 136 so that the anode electrode 134 and the solder pattern SDP may be connected. For example, at least a part of the cathode electrode 135 is exposed from the encapsulation film 136 so that the cathode electrode 135 and the second electrode CE2 may be connected. For example, the encapsulation film 136 may be formed of an insulating material, such as silicon nitride (SiNx) or silicon oxide (SiOx), but the exemplary embodiments of the present disclosure are not limited thereto.

As another example, the encapsulation film 136 may have a structure in which a reflective material is dispersed in a resin layer, but the exemplary embodiments of the present disclosure are not limited thereto. For example, the encapsulation film 136 may be manufactured with reflectors with various structures, but the exemplary embodiments of the present disclosure are not limited thereto. Light emitted from the active layer 132 is upwardly reflected by the encapsulation film 136 so that light extraction efficiency may be improved. For example, the encapsulation film 136 may be a reflective layer, but the exemplary embodiments of the present disclosure are not limited thereto.

According to the present disclosure, it is described that the micro LED (ED) has a vertical structure, but the exemplary embodiments of the present disclosure are not limited thereto. For example, the micro LED (ED) may have a lateral structure or a flip-chip structure.

The first micro LED 130 has been described with reference to FIG. 9 and the second micro LED 140 and the third micro LED 150 may have the substantially same structure as the first micro LED 130. For example, the second micro LED 140 and the third micro LED 150 may be substantially the same as the first semiconductor layer 131, the active layer 132, the second semiconductor layer 133, the anode electrode 134, the cathode electrode 135, and the encapsulation film 136 of the first micro LED 130.

According to the present disclosure, in the active area AA, a first optical layer 117a which encloses or at least partially surrounds the plurality of micro LEDs (ED) may be disposed. For example, the first optical layer 117a may be disposed so as to cover the plurality of micro LEDs (ED) and the bank BNK in the area of the plurality of sub pixels. For example, the first optical layer 117a may cover the bank BNK, a part of the passivation layer 116 and between the plurality of micro LEDs (ED). The first optical layer 117a may be disposed or cover between the plurality of micro LEDs (ED) and between the plurality of banks BNK included in one pixel PX. For example, the first optical layer 117a extends in a row direction and may be spaced apart from each other in a column direction. For example, the first optical layer 117a may be arranged between the passivation layer 116 and the second electrode CE2, but the embodiments of the present disclosure are not limited thereto. For example, the first optical layer 117a may be disposed so as to enclose or at least partially surrounds side portions of the micro LED (ED) and the bank BNK between the passivation layer 116 and the second electrode CE2, but the exemplary embodiments of the present disclosure are not limited thereto. For example, the first optical layer 117a may be a diffusion layer or a sidewall diffusion layer, but the exemplary embodiments of the present disclosure are not limited thereto.

The first optical layer 117a may include an organic insulating material in which micro particles are dispersed, but the exemplary embodiments of the present disclosure are not limited thereto. For example, the first optical layer 117a may include siloxane in which micro metal particles, such as titanium dioxide (TiO2) particles, are dispersed, but the exemplary embodiments of the present disclosure are not limited thereto. Light from the plurality of micro LEDs (ED) is scattered by micro particles dispersed in the first optical layer 117a to be emitted to the outside of the display device 1000. Accordingly, the first optical layer 117a may improve extraction efficiency of light emitted from the plurality of micro LEDs (ED).

For example, the first optical layer 117a may be disposed in each of the plurality of pixels PX or disposed in some pixel PX disposed in the same row together, but the exemplary embodiments of the present disclosure are not limited thereto. For example, the first optical layer 117a is disposed in each of the plurality of pixels PX or the plurality of pixels PX may share one first optical layer 117a. As another example, each of the plurality of sub pixels separately includes the first optical layer 117a, but the exemplary embodiments of the present disclosure are not limited thereto.

According to the present disclosure, in the active area AA, a second optical layer 117b may be disposed on the passivation layer 116. For example, the second optical layer 117b may be disposed so as to enclose or at least partially surrounds the first optical layer 117a. For example, the second optical layer 117b may be in contact with a side surface of the first optical layer 117a. For example, the second optical layer 117b may be disposed in an area between the plurality of pixels PX. However, the exemplary embodiments of the present disclosure are not limited thereto. For example, the second optical layer 117b may be a diffusion layer, a diffusion window, or a window diffusion layer, but the exemplary embodiments of the present disclosure are not limited thereto.

The second optical layer 117b may include an organic insulating material, but the exemplary embodiments of the present disclosure are not limited thereto. The second optical layer 117b may include the same material as the first optical layer 117a, but the exemplary embodiments of the present disclosure are not limited thereto. For example, the first optical layer 117a may include micro particles, but the second optical layer 117b does not include micro particles. For example, the second optical layer 117b includes siloxane, but the exemplary embodiments of the present disclosure are not limited thereto.

For example, a thickness of the first optical layer 117a may be smaller than a thickness of the second optical layer 117b, but the exemplary embodiments of the present disclosure are not limited thereto. Accordingly, in the plan view, an area in which the first optical layer 117a is disposed may include a concave portion which is inwardly dented from an upper surface of the second optical layer 117b.

According to the present disclosure, the second electrode CE2 may be disposed on the first optical layer 117a and the second optical layer 117b. For example, the second electrode CE2 may be electrically connected to the plurality of contact electrodes CCE through a contact hole of the second optical layer 117b. For example, the second electrode CE2 may be disposed on the plurality of micro LEDs (ED). For example, the second electrode CE2 may include a transparent conductive oxide, such as indium tin oxide (ITO) or indium zinc oxide (IZO), but the exemplary embodiments of the present disclosure are not limited thereto. For example, the second electrode CE2 may be disposed to be in contact with the cathode electrode 135. For example, the second electrode CE2 may overlap the first optical layer 117a. For example, the second electrode may cover a plane at the outside of the first optical layer 117a.

The second electrode CE2 may continuously extend in a first direction of the substrate 110. Accordingly, the second electrode may be commonly connected to the plurality of pixels PX disposed in the first direction of the substrate 110. For example, the second electrode CE2 may be commonly connected to the plurality of pixels PX.

According to the present disclosure, the second electrode CE2 may continuously extend on the first optical layer 117a, the second optical layer 117b, and the micro LED (ED). The area in which the first optical layer 117a is disposed may include a concave portion which is inwardly dented from an upper surface of the second optical layer 117b. Accordingly, the first part of the second electrode CE2 disposed on the first optical layer 117a is disposed along the concave portion so that the first part may be disposed to be lower than the second part of the second electrode CE2 disposed on the second optical layer 117b.

The plurality of main sub pixels SPa included in one pixel PX may share the second electrode CE2. For example, the first main sub pixel SP1a, the second main sub pixel SP2a, and the third main sub pixel SP3a included in one pixel PX may share the second electrode CE2.

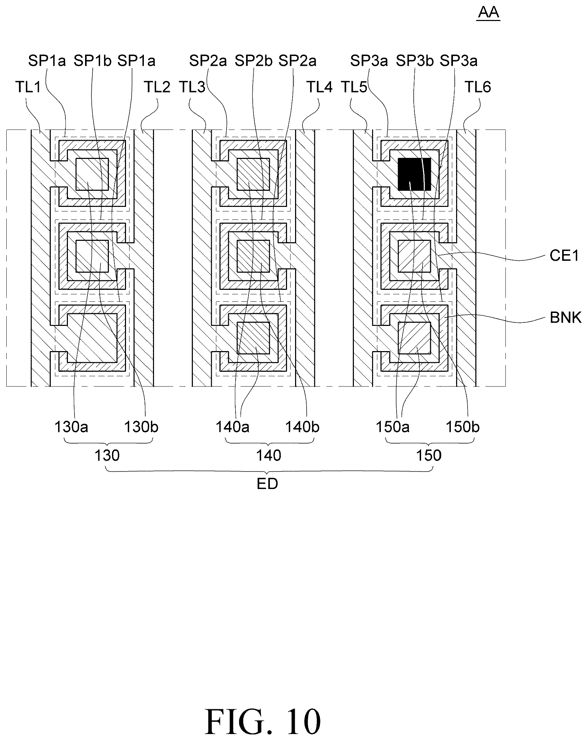

The second electrodes CE2 may be partially formed only in the redundancy sub pixels SPb of some of the plurality of redundancy sub pixels SPb that are included in one pixel PX and operated actually. For example, in case that one pixel PX is operated by a combination of some of the main sub pixels SPa and one redundancy sub pixel SPb, all the main sub pixels SPa and one redundancy sub pixel SPb included in one pixel PX may share the second electrode CE2. In contrast, the second electrode CE2 may not be formed in the remaining redundancy sub pixels SPb that do not operate. For example, the pixel PX, which is disposed at an uppermost end among the plurality of pixels PX in FIG. 7, is the pixel PX operated by a combination of the plurality of main sub pixels Spa, and the second electrodes CE2 may be formed only in the plurality of main sub pixels SPa. For example, the pixel PX, which is disposed at a lowermost end among the plurality of pixels PX in FIG. 7, is the pixel PX operated by a combination of the first redundancy sub pixel SP1b, the second main sub pixel SP2a, and the third main sub pixel SP3a, and the second electrodes CE2 may be formed in the plurality of main sub pixels SPa and the first redundancy sub pixel SP1b. A more detailed description thereof will be described below with reference to FIGS. 10 to 13B.

The third optical layer 117c may be disposed on the second electrode CE2. The third optical layer 117c may be disposed so as to overlap the plurality of micro LEDs (ED) and the first optical layer 117a. The third optical layer 117c is disposed above the second electrode CE2 and the plurality of micro LEDs (ED) so that mura which may be generated in a part of the plurality of micro LEDs (ED) may be improved. For example, when the plurality of micro LEDs (ED) is transferred onto the substrate 110 of the display panel 100, an area in which the interval between the plurality of micro LEDs (ED) is not uniform may be caused due to the process deviation. When the interval between the plurality of micro LEDs (ED) is not uniform, an emission area of each of the plurality of micro LEDs (ED) is not uniformly disposed so that the mura may be visible to a user. Accordingly, the third optical layer 117c which is configured to uniformly diffuse light is configured above the plurality of micro LEDs (ED) so that light emitted from some micro LED (ED) which is visible as mura may be reduced. Accordingly, light emitted from the plurality of micro LEDs (ED) is uniformly diffused by the third optical layer 117c to be extracted to the outside of the display device 1000 so that the luminance uniformity of the display device 1000 may be improved.

The third optical layer 117c may be formed of the same material as the first optical layer 117a, but the embodiments of the present disclosure are not limited thereto. The third optical layer 117c may include an organic insulating material in which micro particles are dispersed, but the exemplary embodiments of the present disclosure are not limited thereto. For example, the third optical layer 117c may include siloxane in which micro metal particles, such as titanium dioxide (TiO2) particles, are dispersed, but the exemplary embodiments of the present disclosure are not limited thereto. For example, the third optical layer 117c is configured by the same material as the first optical layer 117a, but the exemplary embodiments of the present disclosure are not limited thereto. For example, the third optical layer 117c may be a diffusion layer or a upward diffusion layer, but the exemplary embodiments of the present disclosure are not limited thereto.

According to the present disclosure, light from the plurality of micro LEDs (ED) is scattered by micro particles dispersed in the third optical layer 117c to be emitted to the outside of the display device 1000. The third optical layer 117c uniformly mixes light emitted from the plurality of micro LEDs (ED) to further improve the luminance uniformity of the display device 1000. Further, the light extraction efficiency of the display device 1000 may be improved by light scattered from the plurality of micro particles so that the display device 1000 may be driven at a low power.

In the active area AA, a black matrix BM may be disposed on the second electrode CE2, the first optical layer 117a, the second optical layer 117b, and the third optical layer 117c. For example, the contact hole of the second optical layer 117b may be filled with the black matrix BM. The black matrix BM is configured to cover the active area AA to reduce color mixture and external light reflection of light of the plurality of sub pixels. For example, the black matrix BM is disposed in the contact hole through which the second electrode CE2 and the contact electrode CCE are connected so that light leakage between the plurality of adjacent sub pixels may be suppressed.

For example, the black matrix BM may include an opaque material, but the exemplary embodiments of the present disclosure are not limited thereto. For example, the black matrix BM may include an organic insulating material to which black pigment or black dye are added, but the exemplary embodiments of the present disclosure are not limited thereto.

A black matrix BM includes a plurality of transmission holes. The plurality of transmission holes is opening portions that overlap the micro-LEDs ED in the plurality of sub pixels. The light emitted from the plurality of micro-LEDs ED may be extracted to the outside of the display panel 100 through the plurality of transmission holes. The plurality of transmission holes may be disposed to overlap some of the plurality of sub pixels included in one pixel PX.

The plurality of transmission holes may have a larger size than the plurality of micro-LEDs ED. For example, the plurality of transmission holes is formed to be wider than the plurality of micro-LEDs ED in a plan view, which may ensure a margin against a process deviation.

A planar shape of each of the plurality of transmission holes may be a shape corresponding to a planar shape of each of the plurality of micro-LEDs ED. For example, in case that the planar shape of each of the plurality of micro-LEDs ED is a rectangular shape, the planar shape of each of the plurality of transmission holes may be a rectangular shape. However, the planar shape of each of the plurality of transmission holes and the planar shape of each of the plurality of micro-LEDs ED may be different from each other. However, the present disclosure is not limited thereto.

In the active area AA, a cover layer 118 may be disposed on the black matrix BM. The cover layer 118 may protect configurations below the cover layer 118. For example, the cover layer 118 may include an organic insulating material, but the exemplary embodiments of the present disclosure are not limited thereto. For example, the cover layer 118 may include a photo resist, polyimide (PI), or photo acrylic-based material, but the exemplary embodiments of the present disclosure are not limited thereto. For example, the cover layer 118 may be an overcoat layer or an insulating layer, but the exemplary embodiments of the present disclosure are not limited thereto.

A polarization layer 293 may be disposed on the cover layer 118 by means of the first adhesive layer 291. A cover member 200 may be disposed on the polarization layer 293 by means of the second adhesive layer 295. For example, the first adhesive layer 291 and the second adhesive layer 295 may include an optically clear adhesive (OCA), an optically clear resin (OCR), or a pressure sensitive adhesive (PSA), but the exemplary embodiments of the present disclosure are not limited thereto.

According to the present disclosure, a plurality of pad electrodes PE may be disposed on the third insulating layer 115c in the second non-active area NA2. For example, at least a part of the plurality of pad electrodes PE may be exposed from the passivation layer 116. For example, the plurality of pad electrodes PE may be electrically connected to the 2-4-th connection line 122d through a contact hole of the third insulating layer 115c.

The adhesive layer ACF may be disposed on the plurality of pad electrodes PE. The adhesive layer ACF may be an adhesive layer in which conductive balls are dispersed in an insulating material, but the exemplary embodiments of the present disclosure are not limited thereto. When heat or a pressure is applied to the adhesive layer ACF, the conductive balls are electrically connected in a portion applied with the heat or pressure to have a conductive property. The adhesive layer ACF is disposed between the plurality of pad electrodes PE and the flexible circuit board (or flexible film) 400, the flexible circuit board (or flexible film) 400 may be attached or bonded to the plurality of pad electrodes PE. For example, the adhesive layer ACF may be anisotropic conductive film, but the exemplary embodiments of the present disclosure are not limited thereto.

The flexible circuit board (or flexible film) 400 may be disposed on the adhesive layer ACF. The flexible circuit board (or flexible film) 400 may be electrically connected to the plurality of pad electrodes PE through the adhesive layer ACF. Accordingly, a signal output from the flexible circuit board (or flexible film) 400 and the printed circuit board 500 may be transmitted to the pixel drive circuit PD of the active area AA through the plurality of pad electrodes PE, the 2-4-th connection line 122d, the 2-3-th connection line 122c, the 2-2-th connection line 122b, and the 2-1-th connection line 122a.

Hereinafter, a method of configuring the pixel PX of the display device 1000 according to the embodiment of the present disclosure will be described with reference to FIGS. 10 to 13B.

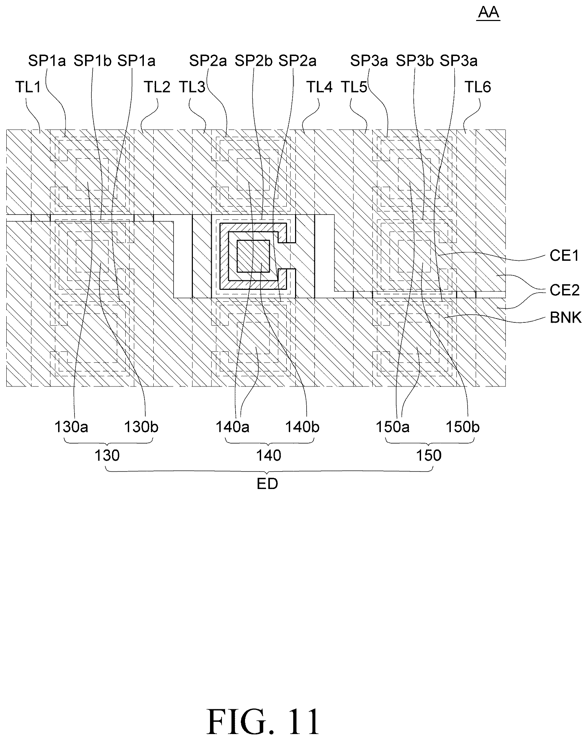

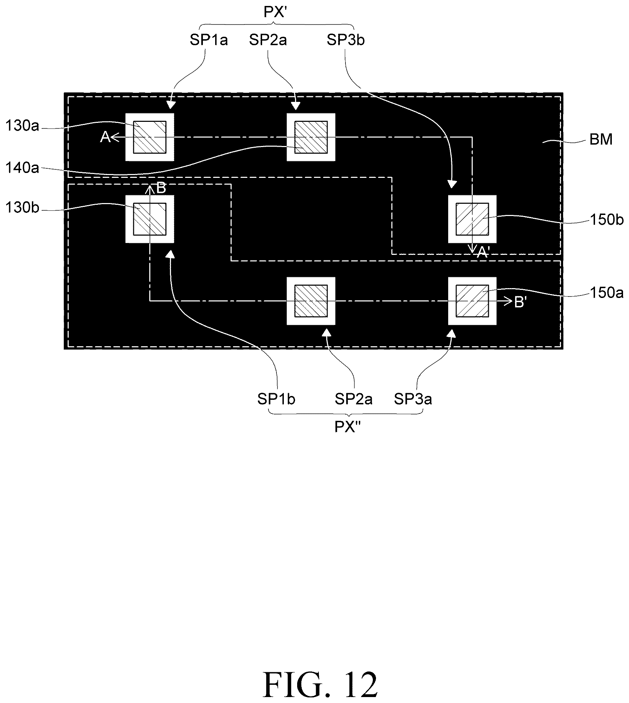

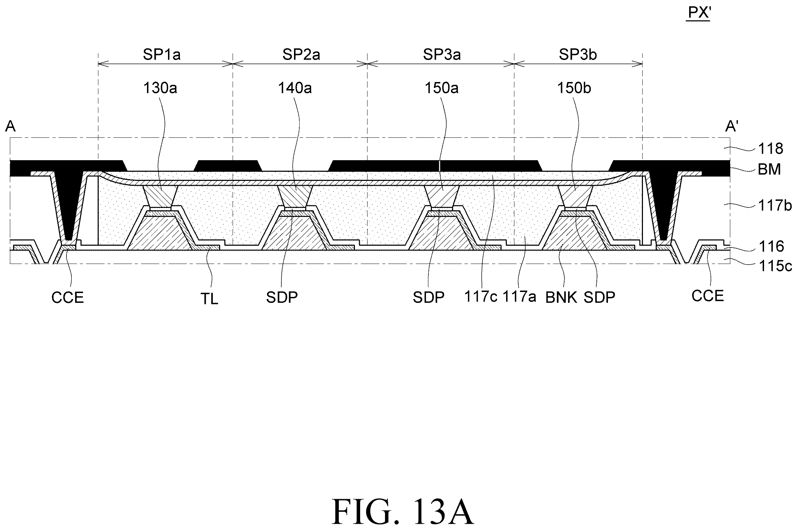

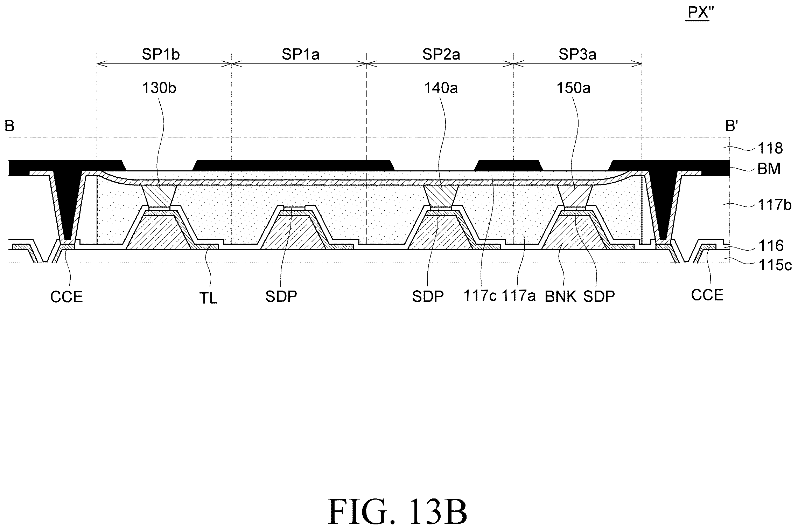

FIGS. 10 to 12 are top plan views of the display device according to the embodiment of the present disclosure. FIGS. 13A and 13B are cross-sectional views of the display device according to the embodiment of the present disclosure. For example, FIGS. 10 to 12 are enlarged top plan views illustrating the display area including the pair of pixels PX. FIG. 13A is a schematic cross-sectional view of a first pixel PX' taken along line A-A' in FIG. 12, and FIG. 13B is a schematic cross-sectional view of a second pixel PX' taken along line B-B' in FIG. 12. FIG. 10 illustrates only the plurality of signal lines TL, the plurality of first electrodes CE1, the plurality of banks BNK, and the plurality of micro-LEDs ED. However, the embodiments of the present disclosure are not limited thereto. FIG. 11 is an enlarged top plan view illustrating a state in which the plurality of second electrodes CE2 are additionally disposed in FIG. 10. FIG. 12 is an enlarged top plan view illustrating a state in which the black matrix BM is additionally disposed in FIG. 11.

With reference to FIGS. 10, 13A, and 13B, the plurality of micro-LEDs ED may be transferred to and disposed in the plurality of sub pixels. For example, the first main micro-LED 130a, the second main micro-LED 140a, the third main micro-LED 150a, the first redundancy micro-LED 130b, the second redundancy micro-LED 140b, and the third redundancy micro-LED 150b may be respectively transferred to the first main sub pixel SP1a, the second main sub pixel SP2a, the third main sub pixel SP3a, the first redundancy sub pixel SP1b, the second redundancy sub pixel SP2b, and the third redundancy sub pixel SP3b.

In this case, a defect may occur on some of the sub pixels because various reasons such as an alignment error between the micro-LED ED and the first electrode CE1 and a non-transfer defect of the micro-LED ED. For example, there may occur a defect in which the third main micro-LED 150a in the third main sub pixel SP3a, which is disposed at an uppermost end of a right side among the plurality of sub pixels, cannot be turned on. In another example, there may occur a non-transfer defect in which the first main micro-LED 130a is not transferred to the first main sub pixel SP1a disposed at a lowermost end of a left side among the plurality of sub pixels.

In the display device 1000 according to the embodiment of the present disclosure, one or more of the plurality of redundancy sub pixels SPb between the plurality of main sub pixels SPa may be used to replace the defective main sub pixel SPa. For example, in the pixel PX including the plurality of main sub pixels SPa disposed at the uppermost end, the third redundancy sub pixel SP3b may be used to replace the defective third main sub pixel SP3a. In the pixel PX including the plurality of main sub pixels SPa disposed at the lowermost end, the first redundancy sub pixel SP1b may be used to replace the defective first main sub pixel SP1a. Therefore, the pixel PX including the plurality of main sub pixels SPa disposed at the uppermost end may emit light by the combination of the first main sub pixel SP1a, the second main sub pixel SP2a, and the third redundancy sub pixel SP3b, and the pixel PX including the plurality of main sub pixels SPa disposed at the lowermost end may emit light by the combination of the first redundancy sub pixel SP1b, the second main sub pixel SP2a, and the third main sub pixel SP3a.

With reference to FIGS. 11, 13A, and 13B, the second electrodes CE2 may be respectively disposed in the plurality of pixels PX, some of the plurality of sub pixels constituting the pixel PX may share one second electrode CE2. For example, the plurality of main sub pixels SPa included in one pixel PX may share one second electrode CE2. The main sub pixels SPa disposed at the lowermost end and included in one pixel PX may share one second electrode CE2. For example, the second electrodes CE2 disposed in the plurality of main sub pixels SPa may be disposed to extend to the redundancy sub pixels SPb used together with the plurality of main sub pixels SPa. For example, the second electrodes CE2 disposed in the plurality of main sub pixels SPa disposed at the uppermost end may extend to the third redundancy sub pixel SP3b, and the third redundancy sub pixel SP3b and the plurality of main sub pixels SPa disposed at the uppermost end may share one second electrode CE2. For example, the second electrode CE2 disposed in the plurality of main sub pixels SPa disposed at the lowermost end may extend to the first redundancy sub pixel SP1b, and the first redundancy sub pixel SP1b and the plurality of main sub pixels SPa disposed at the lowermost end may share one second electrode CE2. Therefore, the plurality of main sub pixels SPa and the redundancy sub pixel SPb, which operate together while sharing the second electrode CE2, may be substantially defined as one pixel PX.

Hereinafter, for convenience of description, the pixel PX, which is operated by the combination of the plurality of main sub pixels SPa and the third redundancy sub pixel SP3b disposed at the uppermost end, will be referred to as a first pixel PX' and described, and the pixel PX, which is operated by the combination of the plurality of main sub pixels SPa and the first redundancy sub pixel SP1b disposed at the lowermost end, will be referred to as a second pixel PX" and described.

With reference to FIGS. 12, 13A, and 13B together, the black matrix BM is disposed on the second electrode CE2. The black matrix BM may include a plurality of transmission holes that overlap the micro-LEDs ED so that light emitted from the micro-LEDs ED may propagate to the outside of the display device 1000. In this case, the plurality of transmission holes may be formed only in some of the micro-LEDs ED that substantially emit light when the display device 1000 operates.

For example, in the first pixel PX' that is operated by the combination of the plurality of main sub pixels SPa and the third redundancy sub pixel SP3b disposed at the uppermost end, the transmission holes of the black matrix BM may be formed to correspond to the first main sub pixel SP1a, the second main sub pixel SP2a, and the third redundancy sub pixel SP3b that substantially emit light. In the first pixel PX', no transmission hole may be formed in the defective third main sub pixel SP3a, and the black matrix BM may be disposed to cover the entire third main sub pixel SP3a.

For example, in the second pixel PX" that is operated by the combination of the plurality of main sub pixels SPa and the first redundancy sub pixel SP1b disposed at the lowermost end, the transmission holes of the black matrix BM may be formed to correspond to the first redundancy sub pixel SP1b, the second main sub pixel SP2a, and the third main sub pixel SP3a that substantially emit light. In the second pixel PX", no transmission hole may be formed in the defective first main sub pixel SP1a, and the black matrix BM may be disposed to cover the entire first main sub pixel SP1a.

In addition, the transmission hole of the black matrix BM may not be formed in some of the redundancy sub pixels SPb that are not used when the display device 1000 operates among the plurality of redundancy sub pixels SPb. For example, because the second redundancy sub pixel SP2b, among the plurality of redundancy sub pixels SPb in FIGS. 10 to 12, is not used together with the first pixel PX' or the second pixel PX", the black matrix BM may be disposed to cover the entire second redundancy sub pixel SP2b.

The disposition of the plurality of transmission holes of the black matrix BM in FIG. 12 is illustrative, and the embodiments of the present disclosure are not limited thereto. For example, the combination of the redundancy sub pixels SPb used together with the plurality of main sub pixels SPa may vary depending on the defective main sub pixel SPa among the plurality of main sub pixels SPa, and the transmission holes of the black matrix BM may also be formed only in the sub pixel that is substantially used.

Therefore, in the display device 1000 according to the embodiment of the present disclosure, the pair of pixels PX share the plurality of redundancy sub pixels SPb, such that the number of redundancy sub pixels SPb and the number of redundancy micro-LEDs ED may be reduced, and manufacturing costs for the display device 1000 may be reduced. For example, in case that the plurality of redundancy micro-LEDs ED are transferred to the plurality of main micro-LEDs ED in a one-to-one manner, the number of redundancy micro-LEDs ED may be increased, which may increase manufacturing costs. In contrast, like the display device 1000 according to the embodiment of the present disclosure, the pair of pixels PX share the plurality of redundancy micro-LEDs ED, such that the number of redundancy micro-LEDs ED may be reduced by half, and manufacturing costs may also be reduced in comparison with the previous case. In addition, because the number of redundancy sub pixels SPb is reduced, a larger number of pixels PX may be disposed, and the high-resolution display device 1000 may be easily implemented.

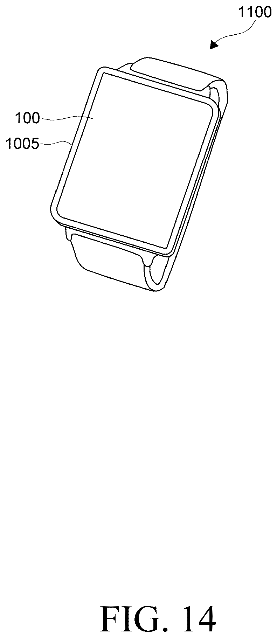

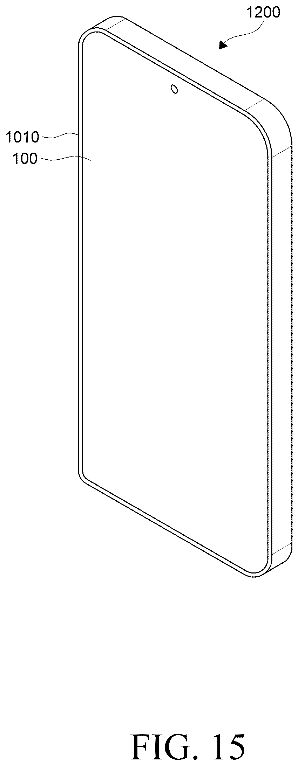

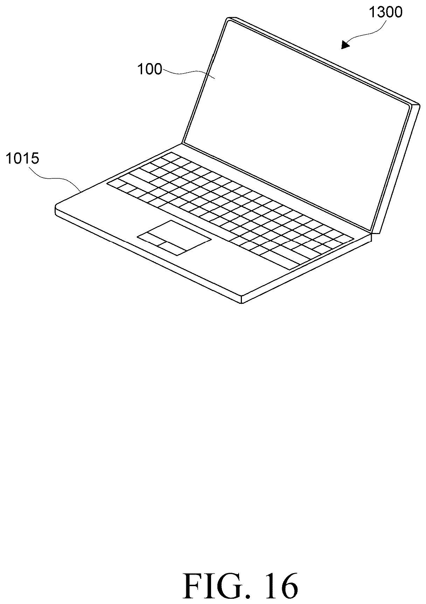

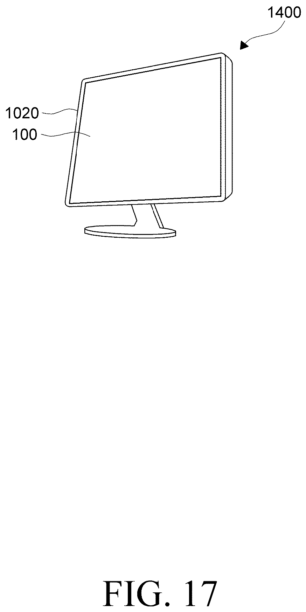

FIGS. 14 to 17 are views illustrating devices to which a display device according to exemplary embodiments of the present disclosure is applied.

Referring to FIGS. 14 to 17, the display device 1000 according to the exemplary embodiments of the present disclosure may be included in various devices or electronic devices. For example, referring to FIGS. 14 to 17, various electronic device may include a wearable device 1100, a mobile device 1200, a notebook 1300, and a monitor or TV 1400, but the exemplary embodiments of the present disclosure are not limited thereto.

The wearable device 1100, the mobile device 1200, the notebook 1300, and a monitor or TV 1400 may include case units 1005, 1010, 1015, and 1020 and display panel 100 and the display device 1000 according to the exemplary embodiments of the present disclosure which have been described in FIGS. 1 to 11B, respectively.

For example, the display device 1000 according to the exemplary embodiment of the present disclosure may be applicable to a mobile device, a video phone, a smart watch, a watch phone, a wearable device, a foldable device, a rollable device, a bendable device, a flexible device, a curved device, a sliding device, a variable device, an electronic note, an electronic book, a portable multimedia player (PMP), a personal digital assistant (PDA), an MP3 player, a mobile medical device, a desktop PC, a laptop PC, a netbook computer, a workstation, a navigation, a display device for a vehicle, a theatrical display device, a television, a wallpaper device, a signage device, a game device, a notebook, a monitor, a camera, a camcorder, and a consumer electronics device.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. All the technical concepts in the equivalent scope of the present disclosure should be construed as falling within the scope of the present disclosure.

## Claims

1. A display device (1000) comprising:
a substrate (110) on which a plurality of pixels (PX) is defined, wherein each of the pixels (PX) comprises a plurality of main sub pixels (SP1a, SP2a, SP3a) and each of the plurality of main sub pixels (SP1a, SP2a, SP3a) comprises a main micro-LED (130a, 140a, 150a);
a plurality of redundancy sub pixels (SP1b, SP2b, SP3b) defined on the substrate (110) and disposed between a pair of pixels (PX) adjacent to each other among the plurality of pixels (PX), wherein each of the plurality of redundancy sub pixels (SP1b, SP2b, SP3b) comprises a redundancy micro-LED (130b, 140b, 150b); and
a pixel drive circuit (PD) disposed on the substrate (100) and electrically connected to the plurality of main micro-LEDs (130a, 140a, 150a) and the plurality of redundancy micro-LEDs (130b, 140b, 150b);
wherein one of the plurality of redundancy sub pixels (SP1b, SP2b, SP3b) disposed between the pair of pixels (PX) is included in one pixel of the pair of pixels (PX) for emitting light, and another one of the plurality of redundancy sub pixels (SP1b, SP2b, SP3b) disposed between the pair of pixels (PX) is included in the other pixel of the pair of pixels (PX) for emitting light.

2. The display device of claim 1, wherein the pair of pixels (PX) is commonly driven by and/or connected to the pixel drive circuit (PD).

3. The display device of claim 1 or 2, further comprising:
a plurality of second electrodes (CE2) disposed on the plurality of main micro-LEDs (130a, 140a, 150a) and the plurality of redundancy micro-LEDs (130b, 140b, 150b) and electrically connected to cathode electrodes (135) thereof, for transmitting a cathode voltage from the pixel drive circuit (PD) to the plurality of main micro-LEDs (130a, 140a, 150a) and the plurality of redundancy micro-LEDs (130b, 140b, 150b),
wherein the main micro-LEDs (130a, 140a, 150a) of the one pixel and the redundancy micro-LED (130b, 140b, 150b) of the one redundancy sub pixel (SP1b, SP2b, SP3b) are connected to a same second electrode (CE2), and the main micro-LEDs (130a, 140a, 150a) of the other pixel and the redundancy micro-LED (130b, 140b, 150b) of the other redundancy sub pixel (SP1b, SP2b, SP3b) are connected to another same second electrode (CE2).

4. The display device according to any one of the preceding claims, wherein the one pixel and the other pixel respectively include a defective main sub pixel (SP1a, SP2a, SP3a), and
the one of the plurality of redundancy sub pixels (SP1b, SP2b, SP3b) included in the pixel is adjacent to the defective main sub pixel (SP1a, SP2a, SP3a) of said one pixel, and the another one of the plurality of redundancy sub pixels (SP1b, SP2b, SP3b) is adjacent to the defective main sub pixel (SP1a, SP2a, SP3a) of said other pixel.

5. The display device according to any one of the preceding claims, further comprising:
a plurality of first electrodes (CE1) disposed on the substrate (110) and electrically connected to the plurality of main micro-LEDs (130a, 140a, 150a) and the plurality of redundancy micro-LEDs (130b, 140b, 150b); and
a plurality of signal lines (TL) electrically connecting the plurality of first electrodes (CE1) and the pixel drive circuit (PD) for transmitting an anode voltage to the plurality of main micro-LEDs (130a, 140a, 150a) and the plurality of redundancy micro-LEDs (130b, 140b, 150b).

6. The display device of claim 5, wherein signal lines (TL) electrically connected to the plurality of main micro-LEDs (130a, 140a, 150a), among the plurality of signal lines, and signal lines electrically connected to the plurality of redundancy micro-LEDs (130b, 140b, 150b), among the plurality of signal lines are arranged alternately and/or in parallel on the substrate (110).

7. The display device of claim 5 or 6, further comprising:
a plurality of banks (BNK) configured to support the plurality of main micro-LEDs (130a, 140a, 150a) and the plurality of redundancy micro-LEDs (130b, 140b, 150b),
wherein each of the plurality of first electrodes (CE1) is disposed between one of the plurality of main micro-LEDs (130a, 140a, 150a) and one of the plurality of banks (BNK) or between one of the plurality of redundancy micro-LEDs (130b, 140b, 150b) and one of the plurality of banks (BNK).

8. The display device according to any one of the preceding claims, wherein each of the pixels (PX) comprises a first main sub pixel (SP1a), a second main sub pixel (SP2a), and a third main sub pixel (SP3a), and the plurality of redundancy sub pixels comprise a first redundancy sub pixel (SP1b), a second redundancy sub pixel (SP2b), and a third redundancy sub pixel (SP3b);
wherein the pair of pixels (PX) are pixels disposed in different rows with the plurality of redundancy sub pixels (SP1b, SP2b, SP3b) interposed therebetween.

9. The display device of claim 8, wherein the first redundancy sub pixel (SP1b) and the first main sub pixels (SP1a) are disposed in a first column, the second redundancy sub pixel (SP2b) and the second main sub pixels (SP2a) are disposed in a second column, and the third redundancy sub pixel (SP3b) and the third main sub pixels (SP3a) are disposed in a third column; and/or
wherein the main sub pixels (SP1a, SP2a, SP3a) of each of the pair of pixels and/or the redundancy pixels (SP1b, SP2b, SP3b) between the pair of pixels are arranged in row direction, respectively.

10. The display device of claim 8 or 9, wherein the first redundancy sub pixel (SP1b) and the first main sub pixels (SP1a) are configured to emit the same color, the second redundancy sub pixel (SP2b) and the second main sub pixels (SP2a) are configured to emit the same color, and the third redundancy sub pixel (SP3b) and the third main sub pixels (SP3a) are configured to emit the same color.

11. The display device of claim 8, 9 or 10, wherein the first main sub pixels (SP1a) are connected to a first signal line (TL1), the second main sub pixels (SP2a) are connected to a third signal line (TL3), and the third main sub pixels (SP3a) are connected to a fifth signal line (TL5), and
wherein the first redundancy sub pixel (SP1b) is connected to a second signal line (TL2), the second redundancy sub pixel (SP2b) is connected to a fourth signal line (TL4) and the third redundancy sub pixel (SP3b) is connected to a sixth signal line (TL6).

12. The display device according to any one of the preceding claims, further comprising:
a black matrix (BM) comprising a plurality of transmission holes configured to transmit light,
wherein the transmission holes overlap those of the plurality of main micro-LEDs (130a, 140a, 150a) and those of the plurality of redundancy micro-LEDs (130b, 140b, 150b) that are included in one of the pixels (PX) for emitting light, and/or
wherein the black matrix (BM) covers at least one defective main sub pixel (SP1a, SP2a, SP3a) and/or those of the plurality of redundancy sub pixels (SP1b, SP2b, SP3b) that are not included in one of the pixels (PX) for emitting light.

13. The display device according to any one of the preceding claims, wherein each of the plurality of main micro-LEDs (130a, 140a, 150a) and the plurality of redundancy micro-LEDs (130b, 140b, 150b) comprises:
an anode electrode (134);
a first semiconductor layer (131) disposed on the anode electrode (134);
an active layer (132) disposed on the first semiconductor layer (131);
a second semiconductor layer (133) disposed on the active layer (132); and
a cathode electrode (135) disposed on the second semiconductor layer (133).

14. The display device of claim 13, further comprising:
a solder pattern (SDP) disposed between the anode electrode (134) and a first electrode (CE1) electrically connected to the pixel drive circuit (PD),
wherein the first electrode (CE1) and the anode electrode (134) are electrically connected by eutectic bonding using the solder pattern (SDP).
